# EUROPEAN PATENT APPLICATION

(11) **EP 2 750 197 A2**
(43) Date of publication of application: **02.07.2014**
(21) Application number: 13199836.1
(22) Date of filing: 30.12.2013
(51) Int. Cl.: H01L 29/66, H01L 29/786

(54) **Thin film transistor, thin film transistor array panel including the same and manufacturing method thereof**

(30) Priority: 31.12.2012 KR 20120158262
(71) Applicant: Samsung Display Co., Ltd., Gyeonggi-Do (KR)
(72) Inventor: Cha, Myoung Geun, Gyeonggi-do (KR); Lee, Yong Su, Gyeonggi-do (KR); Khang, Yoon Ho, Gyeonggi-do (KR); Na, Hyun Jae, Seoul (KR); Yu, Se Hwan, Seoul (KR); Lee, Jong Chan, Gyeonggi-do (KR); Shim, Dong Hwan, Gyeonggi-do (KR)
(74) Representative: Mounteney, Simon James

(57) **Abstract**

A thin film transistor array panel including a substrate; a channel region disposed on the substrate and including oxide semiconductor disposed on the substrate; a source electrode and a drain electrode connected to the oxide semiconductor and facing each other at both sides, centered on the oxide semiconductor; an insulating layer disposed on the oxide semiconductor; and a gate electrode disposed on the insulating layer. The drain electrode includes a first drain region and a second drain region; the charge mobility of the first drain region is greater than that of the second drain region, the source electrode includes a first source region and a second source region, and the charge mobility of the first source region is greater than that of the second source region.

## Description

### BACKGROUND

### FIELD

The present invention relates to a thin film transistor, a thin film transistor array panel including the same, and a manufacturing method thereof.

### DISCUSSION OF THE BACKGROUND

A display device includes a thin film transistor for switching each pixel. The thin film transistor forms a switching element having three terminals, including a gate electrode which receives a switching signal, a source electrode which receives a data voltage, and a drain electrode outputting a data signal. Further, the thin film transistor includes an active layer overlapping the gate electrode, the source electrode, and the drain electrode as a channel layer, and the active layer is mainly formed of amorphous silicon as a semiconductor material.

However, as a size of a display is increased, a development of a thin film transistor that can be driven at ultra-high speed is urgently needed. In particular, the amorphous silicon that has been mainly used as the active layer has low electron mobility and requires deposition equipment utilizing an expensive vacuum process for using chemical vapor deposition (CVD), sputtering, and the like.

Therefore, an oxide semiconductor which is formed by a coating process or an ultra low-price printing process while having high electron mobility has been developed.

When the gate electrode of the thin film transistor forms a parasitic capacitance along with the source electrode or the drain electrode, the capability of the thin film transistor as a switching element may be reduced as a result of the parasitic capacitance.

In order to reduce the parasitic capacitance, a portion of the oxide semiconductor may be used as a source region and a drain region in a self-alignment manner. In this case, upon forming a contact hole exposing the source region and the drain region, charge mobility is reduced as a result of the exposure of the oxide semiconductor, such that the oxide semiconductor may have conductivity insufficient to be used as the source region and the drain region.

The above information disclosed in this Background section is only for enhancement of understanding of the background of the invention and therefore it may contain information that does not form the prior art.

### SUMMARY

The present invention sets-out to provide a thin film transistor, a thin film transistor array panel including the same, and a manufacturing method thereof capable of preventing deterioration in the performance of the thin film transistor resulting from low conductivity of a source region and a drain region upon forming a contact hole exposing the source region and the drain region, even when the thin film transistor is formed of oxide semiconductor and a portion of the oxide semiconductor is formed as the source region and the drain region by a self-alignment manner.

Additional features of the invention will be set forth in the description which follows, and in part will be apparent from the description, or may be learned by practice of the invention.

An embodiment of the present invention discloses a thin film transistor, including: a channel region including an oxide semiconductor; a source electrode and a drain electrode connected to the channel region and disposed opposite each other with respect to the channel region; an insulating layer disposed on the channel region; a gate electrode disposed on the insulating layer; and a passivation layer disposed on the source electrode and the drain electrode. The drain electrode includes a first drain region and a second drain region, the passivation layer has a first contact hole exposing the first drain region, and a charge mobility of the first drain region is equal to or greater than that of the second drain region.

An embodiment of the present invention also discloses a thin film transistor array panel, including: a substrate; a channel region disposed on the substrate and including an oxide semiconductor; a source electrode and a drain electrode connected to the channel region and disposed opposite each other with respect to the channel region; an insulating layer disposed on the channel region; and a gate electrode disposed on the insulating layer. The drain electrode includes a first drain region and a second drain region, a charge mobility of the first drain region is greater than that of the second drain region, the source electrode includes a first source region and a second source region, and a charge mobility of the first source region is greater than that of the second source region.

An embodiment of the present invention also discloses a manufacturing method of a thin film transistor array panel, including: depositing and patterning a semiconductor layer including an oxide semiconductor material on an insulating substrate to form a semiconductor pattern; depositing an insulating material on the semiconductor pattern to form an insulating material layer; forming a gate electrode on the insulating material layer; patterning the insulating material layer using the gate electrode as an etch mask to form an insulating layer and expose a portion of the semiconductor pattern; and performing first reduction processing on a portion of the exposed semiconductor pattern, centered on the semiconductor covered with the gate electrode, to form a source electrode and a drain electrode facing each other with respect to the semiconductor; forming a passivation layer having a source contact hole exposing a first portion of the source electrode and a drain contact hole exposing a second portion of the drain electrode on the source electrode and the drain electrode; and performing second reduction processing on the first portion of the source electrode and the second portion of the drain electrode exposed through the source contact hole and the drain contact hole to form the first source region and the first drain region.

At least some of the above and other features of the invention are set out in the claims.

It is to be understood that both the foregoing general description and the following detailed description are given by way of example and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.
FIG. 1 is a cross-sectional view of a thin film transistor array panel including a thin film transistor according to an embodiment of the present invention.
FIG. 2, FIG. 3, FIG. 4, FIG. 5, FIG. 6, FIG. 7, FIG. 8, FIG. 10, and FIG. 11 are cross-sectional views sequentially illustrating a manufacturing method of the thin film transistor array panel according to the embodiment of the present invention illustrated in FIG. 1.
FIG. 9 is an electron micrograph illustrating a portion of the thin film transistor illustrated in FIG. 8.
FIG. 12, FIG. 13. and FIG. 14 are graphs illustrating a depth profile according to one Experimental Example of the present invention.
FIG. 15 is a cross-sectional view of a thin film transistor array panel including a thin film transistor according to another embodiment of the present invention.
FIG. 16, FIG. 17, FIG. 18, FIG. 19, FIG. 20, FIG. 21, FIG. 22, FIG. 23, FIG. 24, FIG. 25, FIG. 26, FIG. 27, FIG. 28, FIG, 29 , and FIG. 30 are cross-sectional views sequentially illustrating a manufacturing method of the thin film transistor array panel according to the embodiment of the present invention illustrated in FIG 15.
FIG. 31 is a cross-sectional view of a thin film transistor array panel including a thin film transistor according to another embodiment of the present invention.
FIG. 32, FIG. 33, FIG. 34, FIG. 35, FIG. 36, FIG. 37, FIG. 38, FIG. 39, FIG. 40, and FIG. 41 are cross-sectional views sequentially illustrating a manufacturing method of the thin film transistor array panel illustrated in FIG. 31.
FIG. 42 is a diagram illustrating charge mobility of a source region and a drain region of the thin film transistor according to one Experimental Example of the present invention.

### DETAILED DESCRIPTION

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

It will be understood that when an element or layer is referred to as being "on," "connected to," or "coupled to" another element or layer, it can be directly on, directly connected to, or directly coupled to the other element or layer, or intervening elements or layers may be present. In contrast, when an element or layer is referred to as being "directly on," "directly connected to," or "directly coupled to" another element or layer, there are no intervening elements or layers present. It will be understood that for the purposes of this disclosure, "at least one of X, Y, and Z" can be construed as X only, Y only, Z only, or any combination of two or more items X, Y, and Z (e.g., XYZ, XYY, YZ, ZZ).

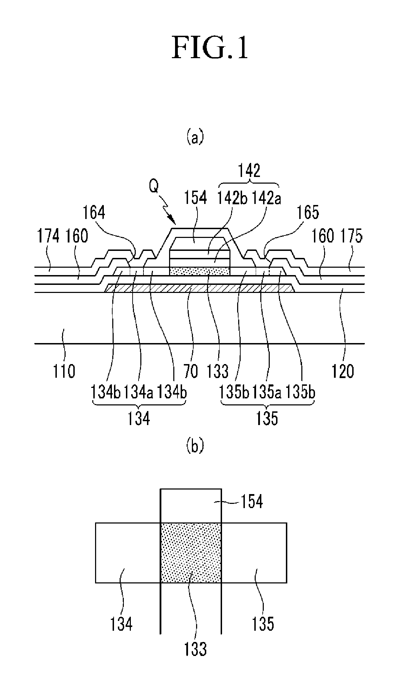

A thin film transistor and a thin film transistor array panel according to an embodiment of the present invention will first be described with reference to FIG. 1.

FIG. 1 is a cross-sectional view of a thin film transistor array panel including a thin film transistor according to an embodiment of the present invention.

Referring to FIG. 1, a light blocking layer 70 may be disposed on an insulating substrate 110 that may be formed of glass, plastic, and the like. The light blocking layer 70 may prevent light from being incident on oxide semiconductor to be deposited later to prevent performance of the oxide semiconductor from deteriorating as a result of the light incident on the oxide semiconductor. The light blocking layer 70 may be formed of an organic insulating material, an inorganic insulating metal, a conductive material such as metal, and the like, and may be formed in a single layer or a multilayer. However, the light blocking layer 70 may be omitted according to process conditions. In detail, when light is not irradiated from below the insulating substrate 110, for example, when a thin film transistor according to an embodiment of the present invention is used for an organic light emitting display device, and the like, the light blocking layer 70 may be omitted.

A buffer layer 120 is disposed on the light blocking layer 70. The buffer layer 120 may be formed of insulating oxide, such as silicon oxide (SiOx), aluminum oxide (Al₂O₃), hafnium oxide (HfO₃), yttrium oxide (Y₂O₃), and the like. The buffer layer 120 may prevent an impurity from the insulating substrate 110 from being introduced into a semiconductor to be deposited later to protect the semiconductor and improve interface characteristics of the semiconductor.

A channel region 133, a source electrode 134, and a drain electrode 135 are disposed on the buffer layer 120.

The channel region 133 may be formed of an oxide semiconductor. The oxide semiconductor may be a metal oxide semiconductor and may include at least one of metals such as zinc (Zn), indium (In), gallium (Ga), tin (Sn), titanium (Ti), and the like, and an oxide thereof. For example, the oxide semiconductor may include at least one of zinc oxide (ZnO), zinc-tin oxide (ZTO), zinc-indium oxide (ZIO), indium oxide (InO), titanium oxide (TiO), indium-gallium-zinc oxide (IGZO), and indium-zinc-tin oxide (IZTO)

When the light blocking layer 70 is present, the channel region 133 may be covered with the light blocking layer 70.

The source electrode 134 and the drain electrode 135 are disposed opposite each other with respect to the channel region 133 and are separated from each other. Further, the source electrode 134 and the drain electrode 135 are connected to the channel region 133.

The source electrode 134 and the drain electrode 135 have conductivity and include the same material as an oxide semiconductor material forming the channel region 133 and a reduced semiconductor material. Metals such as indium (In), and the like, which are included in the oxide semiconductor material, may be precipitated on surfaces of the source electrode 134 and the drain electrode 135.

The source electrode 134 includes a first source region 134a and a second source region 134b disposed around the first source region 134a. The drain electrode 135 also includes a first drain region 135a and a second drain region 135b disposed around the first drain region 135a. In an embodiment of the present invention, a charge mobility of the first source region 134a is equal to or greater than that of the second source region 134b and a charge mobility of the first drain region 135a is equal to or greater than that of the second drain region 135b. For example, the charge mobility of the first drain region 135a may be greater than or equal to 1x10¹⁷ and the charge mobility of the second drain region 135b may be less than or equal to 1x10¹⁷.

The first source region 134a of the source electrode 134 is disposed under a first source contact hole 164 to be described below. In a region in which the first source contact hole 164 contacts the source electrode 134, an edge of the first source contact hole 164 is adjacent to a boundary portion between the first source region 134a and the second source region 134b. According to a thin film transistor array panel according to another embodiment of the present invention, the edge of the first source contact hole 164 may coincide with a boundary between the first source region 134a and the second source region 134b. Similarly, the first drain region 135a of the drain electrode 135 is disposed below the first drain contact hole 165 to be described below, in the region in which the first drain contact hole 165 contacts the drain electrode 135, the edge of the first drain contact hole 165 is adjacent a boundary between the first drain region 135a and the second drain region 135b, and according to the thin film transistor array panel according to another embodiment of the present invention, the edge of the first drain contact hole 165 may coincide with the boundary between the first drain region 135a and the second drain region 135b.

The first source region 134a of the source electrode 134 may be electrically connected to a data wire transferring a data signal, the first drain region 135a of the drain electrode 135 may be electrically connected to a pixel electrode (not illustrated), an electric field is generated by voltage applied to the pixel electrode and an opposed electrode (not illustrated), and gray representation can be made according to the electric field.

An insulating layer 142 is disposed on the channel region 133. The insulating layer 142 may cover the channel region 133. Further, the insulating layer 142 may not overlap the source electrode 134 or the drain electrode 135.

The insulating layer 142 includes a first layer 142a and a second layer 142b disposed on the first layer. The first layer 142a includes an insulating oxide such as silicon oxide (SiOx), aluminum oxide (Al₂O₃), hafnium oxide (HfO₃), yttrium oxide (Y₂O₃), and the like, to improve interface characteristics of the channel region 133 and prevent an impurity from penetrating into the channel region 133. The second layer 142b may be formed of various insulating materials such as silicon nitride (SiNx), silicon oxide (SiOx), and the like. For example, the insulating layer 142 may include the first layer 142a of aluminum oxide (AlOx) and the second layer 142b of silicon oxide (SiOx) and may include the first layer 142a of silicon oxide (SiOx) and the second layer 142b of silicon nitride (SiNx). However, the insulating layer 142 is not limited thereto.

In the illustrated embodiment, the insulating layer 142 includes the first layer 142a and the second layer 142b disposed on the first layer. Alternatively, the insulating layer 142 may be a single layer or have more than two layers.

When the insulating layer 142 is a single layer, the insulating layer 142 may be formed of insulating oxide, such as silicon oxide (SiOx), aluminum oxide (Al₂O₃), hafnium oxide (HfO₃), yttrium oxide (Y₂O₃), and the like. The insulating layer 142 may improve the interface characteristics of the channel region 133 and prevent an impurity from penetrating into the channel region 133.

The insulating layer 142 may be formed of silicon oxynitride. When the insulating layer 142 is formed in a single layer of silicon oxynitride, because the insulating layer 142 is adjacent to the semiconductor layer, the oxygen concentration distribution in the silicon oxynitride may be increased. As such, at the contact surface between the semiconductor layer and the silicon oxide layer, the oxygen concentration may be sufficient within the semiconductor to prevent the degradation of the channel layer.

A thickness of the insulating layer 142 may be appropriately controlled so as to maximize the characteristics of the thin film transistor.

The gate electrode 154 is disposed on the insulating layer 142. Edges of the gate electrode 154 and edges of the insulating layer 142 may be aligned so as to substantially coincide with each other.

The gate electrode 154 includes a portion overlapping the channel region 133, and the channel region 133 is covered with the gate electrode 154. The source electrode 134 and the drain electrode 135 are disposed at both sides of the channel region 133 with respect to the gate electrode 154, and the source electrode 134 and the drain electrode 135 may not substantially overlap the gate electrode 154. Therefore, parasitic capacitance between the gate electrode 154 and the source electrode 134 or parasitic capacitance between the gate electrode 154 and the drain electrode 135 may be small.

The gate electrode 154 may be formed of at least one of aluminum-based metals such as aluminum (Al), aluminum alloy, and the like, silver-based metals such as silver (Ag), silver alloy, and the like, copper-based metals such as copper (Cu), copper alloy, and the like, molybdenum-based metals such as molybdenum (Mo), molybdenum alloy, and the like, chromium (Cr), titanium (Ti), and tantalum (Ta). The gate electrode 154 may have a single layer structure or a multilayer structure.

In the embodiment illustrated, a boundary between the channel region 133 and the source electrode 134, or a boundary between the channel region 133 and the drain electrode 135, may be substantially aligned so as to coincide with the edges of the gate electrode 154 and the insulating layer 142. However, according to a thin film transistor and a thin film transistor array panel according to another embodiment of the present invention, the boundary between the channel region 133 and the source electrode 134 or the drain electrode 135 may be disposed slightly more inwardly from the edges of the gate electrode 154 and the insulating layer 142.

The gate electrode 154, the source electrode 134, and the drain electrode 135 form a thin film transistor (TFT) Q along with the channel region 133, and the gate electrode 154 becomes a control terminal of the thin film transistor Q, the source electrode 134 becomes an input terminal of the thin film transistor Q, and the drain electrode 135 becomes an output terminal of the thin film transistor Q. In this case, the channel of the thin film transistor is formed in the channel region 133.

A passivation layer 160 is disposed on the gate electrode 154, the source electrode 134, the drain electrode 135, and the buffer layer 120. The passivation layer 160 may be formed of an inorganic insulating material, such as silicon nitride, silicon oxide, and the like, or an organic insulating material, etc. The passivation layer 160 may have a first source contact hole 164 exposing the source electrode 134 and a first drain contact hole 165 exposing the drain electrode 135.

A data input electrode 174 and a data output electrode 175 may be disposed on the passivation layer 160. The data input electrode 174 may be electrically connected to the source electrode 134 of the thin film transistor Q through the first source contact hole 164 of the passivation layer 160 and the data output electrode 175 may be electrically connected to the drain electrode 135 of the thin film transistor Q through the first drain contact hole 165 of the passivation layer 160. The data output electrode 175 is connected to the pixel electrode (not illustrated) or may be a pixel electrode.

A color filter (not illustrated) or an organic layer (not illustrated) formed of an organic material may be further disposed on the passivation layer 160 and the data input electrode 174 and the data output electrode 175 may also be disposed thereon.

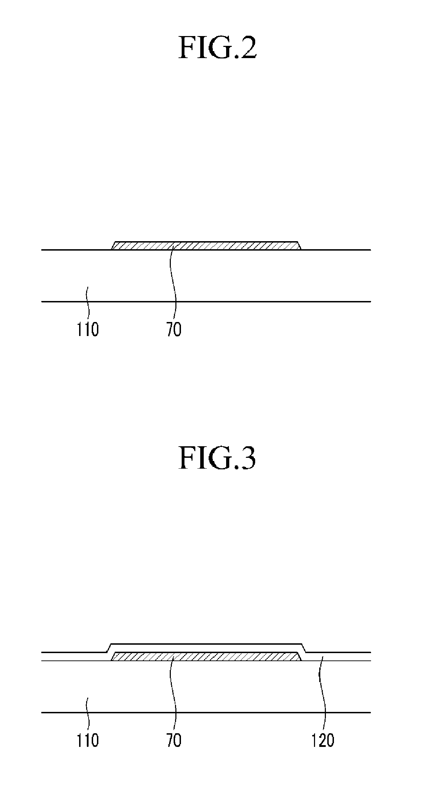

Next, a manufacturing method of a thin film transistor according to the embodiment of the present invention will be described with reference FIGS. 2 to FIG. 11 along with FIG. 1 described above.

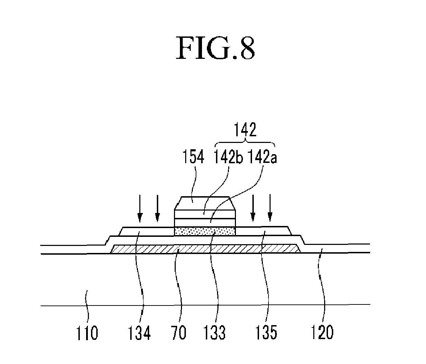

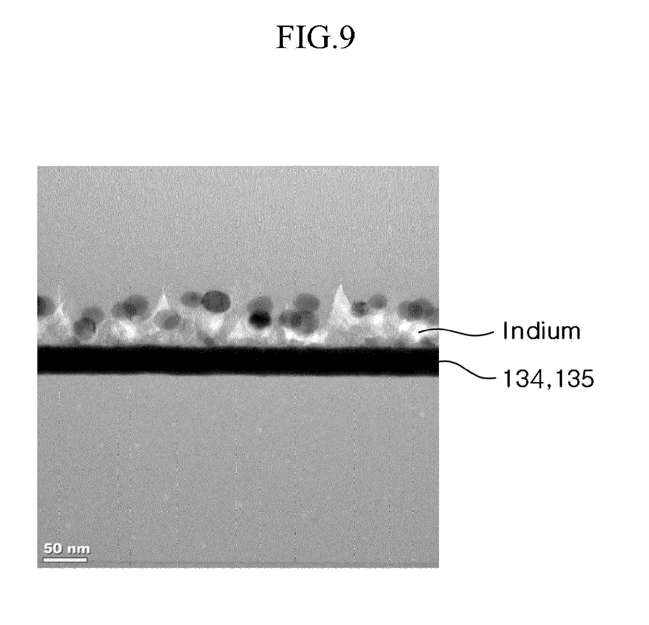

FIGS. 2 to 8 and FIGS. 10 and 11 are cross-sectional views sequentially illustrating a manufacturing method of the thin film transistor array panel illustrated in FIG. 1 according to a manufacturing method of a thin film transistor according to an embodiment of the present invention. FIG. 9 is an electron micrograph illustrating a portion of the thin film transistor illustrated in FIG. 8.

Referring first to FIG. 2, the light blocking layer 70 including at least one of the organic insulating material, the inorganic insulating material, and the conductive material such as metal, and the like, is formed on the insulating substrate 110, which may be formed of glass, plastic, and the like. The forming of the light blocking layer 70 may be omitted according to the process conditions.

Next, as illustrated in FIG. 3, the buffer layer 120 formed of the insulating material including at least one oxide of silicon oxide (SiOx), aluminum oxide (Al₂O₃), hafnium oxide (HfO₃), and yttrium oxide (Y₂O₃) is formed on the light blocking layer 70 by methods such as chemical vapor deposition (CVD), and the like.

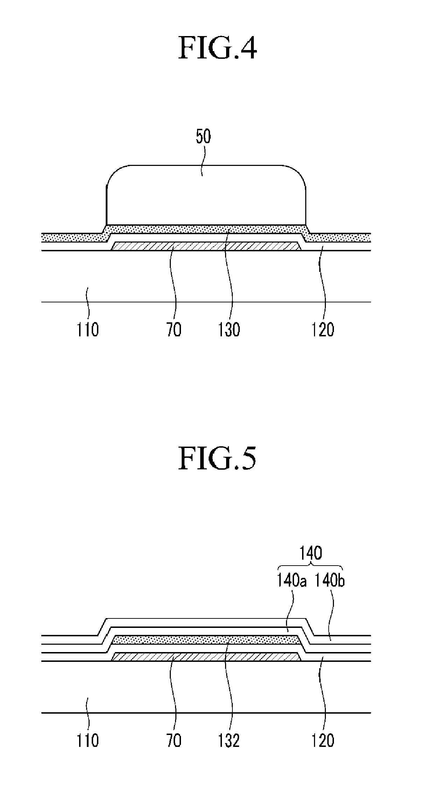

Next, as illustrated in FIG. 4, an oxide including at least one of metals, such as zinc (Zn), indium (In), gallium (Ga), tin (Sn), titanium (Ti), and the like, is deposited on the buffer layer 120. For example, the semiconductor layer 130 including oxide semiconductor materials of zinc oxide (ZnO), zinc-tin oxide (ZTO), zinc-indium oxide (ZIO), indium oxide (InO), titanium oxide (TiO), indium-gallium-zinc oxide (IGZO), and indium-zinc-tin oxide (IZTO), and the like may be deposited. The semiconductor layer 130 may be deposited by a coating process or a ultra low-cost printing process.

Next, a photosensitive film such as a photoresist, and the like, is coated on the semiconductor layer 130 and is exposed to form a first photosensitive film pattern 50. The first photosensitive film pattern 50 may overlap at least a portion of the light blocking layer 70.

Next, the semiconductor layer 130 is etched using the first photosensitive film pattern as a mask to form a semiconductor pattern 132, and then the first photosensitive film pattern 50 may be removed.

As illustrated in FIG. 5, the insulating material layer 140 is formed on the semiconductor pattern 132 and the buffer layer 120. The insulating material layer 140 may also be formed in a multilayer structure including the first layer 140a including the insulating oxide such as silicon oxide (SiOx), and the like, and the second layer 140b including the insulating material. However, the insulating material layer 140 may also be formed in a single layer including the insulating oxide such as silicon oxide (SiOx), and the like.

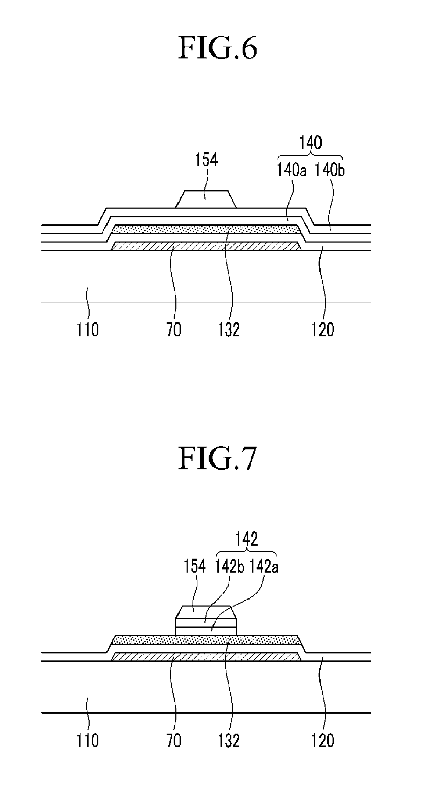

Next, referring to FIG. 6, the conductive material such as metal, and the like is deposited on the insulating material layer 140 and is patterned to form the gate electrode 154. The gate electrode 154 is formed on a portion of the semiconductor pattern 132 so that two portions of the semiconductor pattern 132 disposed at both sides of an overlapping portion of the gate electrode 154 and the semiconductor pattern 132 are not covered with the gate electrode 154.

Next, as illustrated in FIG. 7, the insulating material layer 140 is patterned by using the gate electrode 154 as the etch mask to form the insulating layer 142. As a patterning method of the insulating material layer 140, a dry etching method may be used and the buffer layer 120 may be prevented from being etched by controlling etch gas and etch time.

The insulating layer 142 may be formed in the first layer 142a including the insulating oxide and the second layer 142b including the insulating material. However, the insulating layer 142 may be formed in a single layer.

Therefore, the gate electrode 154 and the insulating layer 142 substantially have the same planar shape. Further, two portions that are disposed at both sides of a portion of the overlapping portion of the gate electrode 154 and the semiconductor pattern 132 in the semiconductor pattern 132, and thus are not covered with the gate electrode 154, are exposed.

According to the manufacturing method of the thin film transistor according to an embodiment of the present invention, the semiconductor pattern 132 and the gate electrode 154 are formed by different photolithography processes, but the semiconductor pattern 132, the insulating layer 142, and the gate electrode 154 may also be formed by performing the photolithography process once after sequentially depositing the semiconductor layer 130, the insulating material layer 140, and the gate electrode metal layer. The method will be described in detail below.

Referring to FIG. 8, the two exposed portions of the semiconductor pattern 132 are subjected to first reduction processing to form the source electrode 134 and the drain electrode 135 having conductivity. In addition, the semiconductor pattern 132 that is covered with the insulating layer 142, and thus is not reduced, becomes the channel region 133.

As the reduction processing method of the exposed semiconductor pattern 132, plasma processing using gas including hydrogen (H₂) such as hydrogen (H₂), phosphine (PH₃), ammonia (NH₃), silane (SiH₄), methane (CH₄), acetylene (C₂H₂), diborane (B₂H₆), germane (GeH₄), hydrogen selenide (H₂Se), and hydrogen sulfide (H₂S) or gas plasma including fluorine (F) such as octa-fluoro-cyclo-butane (C₄F₈), nitrogen trifluoride (NF₃), and fluorine formaldehyde (CHF₃) may be used. At least a portion of the semiconductor material forming the exposed semiconductor pattern 132 that is subjected to the reduction processing is reduced, and thus only the metal bonding may remain. Therefore, the exposed portion of the semiconductor pattern 132 that is subjected to the reduction processing has conductivity.

In more detail, when the gas plasma processing using gas including the hydrogen H₂ is performed, the hydrogen gas is introduced into the exposed portion of the semiconductor pattern 132 to increase carrier concentration and reduce sheet resistance Rs, such that the exposed portion of the semiconductor pattern 132 has conductivity. Further, at the time of the gas plasma processing using gas including hydrogen, a metal component of the semiconductor material, for example, indium (In), and the like is precipitated on the exposed portion of the surface of the semiconductor pattern 132, such that the exposed portion of the semiconductor pattern 132 has conductivity.

Further, when the gas plasma processing using gas including fluorine (F) is performed, the fluorine (F) is introduced into the exposed portion of the surface of the semiconductor pattern 132 such that oxygen within the semiconductor pattern 132 is reduced to increase the carrier concentration, such that the exposed portion of the semiconductor pattern 132 has conductivity.

In connection with this, one Experimental Example of the present invention will be described below in more detail.

As described above, at the time of the reduction processing of the semiconductor pattern 132, a metal component of the semiconductor material, for example, indium (In), and the like may be precipitated on the exposed portion of the surface of the semiconductor pattern 132. A thickness of the precipitated metal layer may be set to be 200 nm or less.

FIG. 9 illustrates indium (In) particles which are precipitated on the surfaces of the source electrode 134 and the drain electrode 135 when the semiconductor material forming the semiconductor pattern 132 includes indium (In).

According to an embodiment of the present invention, the boundary between the channel region 133 and the source electrode 134, or the boundary between the channel region 133 and the drain electrode 135, may be substantially aligned so as to match with the edges of the gate electrode 154 and the insulating layer 142. However, at the time of the reduction processing of the semiconductor pattern 132, the semiconductor pattern 132 under the edge portion of the insulating layer 142 may be reduced to some extent, such that the boundary between the channel region 133 and the source electrode 134 or the drain electrode 135 may be disposed more inwardly from the edges of the gate electrode 154 and the insulating layer 142.

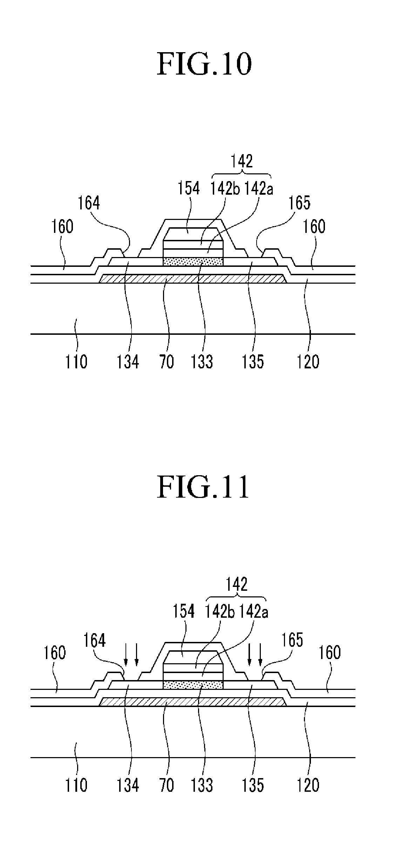

Next, referring to FIG. 10, the insulating material is coated on the gate electrode 154, the source electrode 134, the drain electrode 135, and the buffer layer 120 to form the passivation layer 160. Next, the passivation layer 160 is patterned to form the first source contact hole 164 exposing the source electrode 134 and the first drain contact hole 165 exposing the drain electrode 135. In this case, the exposed portions of the source electrode 134 and the drain electrode 135 through the first source contact hole 164 and the first drain contact hole 165 contact an etchant, etch gas, or oxygen in the air, such that at least a portion thereof may be oxidized again. In this case, the oxidized region may have a low charge mobility.

Next, as illustrated in FIG. 11, the exposed portions of the source electrode 134 and the drain electrode 135 through the first source contact hole 164 and the first drain contact hole 165 are again subjected to the second reduction processing, and thus are oxidized, such that the charge mobility of the region having lower charge mobility than that of the circumference thereof may be equal to or greater than that of the circumference thereof.

Therefore, as illustrated in FIG. 1, the portion of the source electrode 134 disposed around the first source region 134a disposed at the exposed portion by the first source contact hole 164 becomes the second source region 134b and the portion of the drain electrode 135 disposed around the first drain region 135a disposed at the exposed portion by the first drain contact hole 165 becomes the second drain region 135b. The first source region 134a and the first drain region 135a are subjected to the first reduction processing to have conductivity and then be partially oxidized, and are again subjected to the second reduction processing, such that the first source region 134a and the first drain region 135a may have a charge mobility equal to or greater than that of the second source region 134b and second drain region 135b. For example, the charge mobility of the first drain region 135a may be greater than or equal to 1x10¹⁷ or more and the charge mobility of the second drain region 135b may be less than or equal to 1x10¹⁷.

According to a manufacturing method of the thin film transistor array panel according to another embodiment of the present invention, the passivation layer 160 illustrated in FIG. 10 may be patterned to simultaneously perform a process of forming the first source contact hole 164 exposing the source electrode 134 and the first drain contact hole 165 exposing the drain electrode 135, and a process of performing the second reduction processing illustrated in FIG. 11. In this case, the first source region 134a and the first drain region 135a are subjected to the first reduction processing to have conductivity and then are subjected to the second reduction processing again, such that the charge mobility of the first source region 134a and the first drain region 135a may be equal to or greater than that of the second source region 134b and the second drain region 135b. For example, the charge mobility of the first drain region 135a may be greater than or equal to 1x10¹⁷ and the charge mobility of the second drain region 135b may be less than or equal to 1x10¹⁷.

Finally, as illustrated in FIG. 1, the data input electrode 174 and the data output electrode 175 are formed on the passivation layer 160, such that the data input electrode 174 is connected to the first source region 134a of the source electrode 134 and the data output electrode 175 is connected to the first drain region 135a of the drain electrode 135.

According to the thin film transistor Q and a manufacturing method of a display panel including the thin film transistor Q according to the embodiment of the present invention, the data input electrode 174 is connected to the first source region 134a of the source electrode 134 having a charge mobility equal to or greater than that of the second source region 134b, and the data output electrode 175 is connected to the first drain region 135a of the drain electrode 135 having a charge mobility equal to or greater than that of the second drain region 135b, so as to provide a more positive electrical connection between the data input electrode 174 and the source electrode 134, and between the data output electrode 175 and the drain electrode 135.

Further, in the thin film transistor Q according to the embodiment of the present invention, the gate electrode 154 does not substantially overlap the source electrode 134 or the drain electrode 135, such that the parasitic capacitance between the gate electrode 154 and the source electrode 134 or the parasitic capacitance between the gate electrode 154 and the drain electrode 135 may be very small. Therefore, the on/off characteristics as the switching element of the thin film transistor Q may be improved.

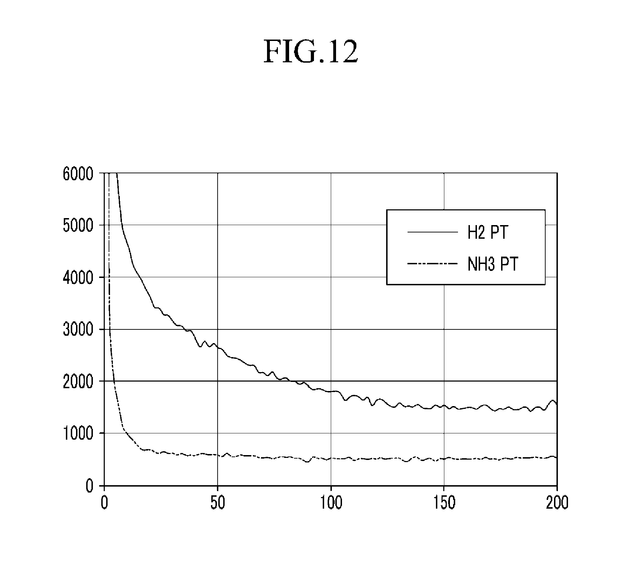

Next, one Experimental Example of the present invention will be described with reference to FIGS. 12 to 14. FIGS. 12 to 14 are graphs illustrating a depth profile according to one Experimental Example of the present invention.

In the present Experimental Example, after the gas plasma processing using hydrogen (H₂) gas and ammonia (NH₃) gas is performed on the surface of the semiconductor pattern formed of indium-gallium-zinc oxide (IGZO), the results obtained by measuring the depth profile of the hydrogen concentration of the semiconductor pattern are illustrated in FIG. 12.

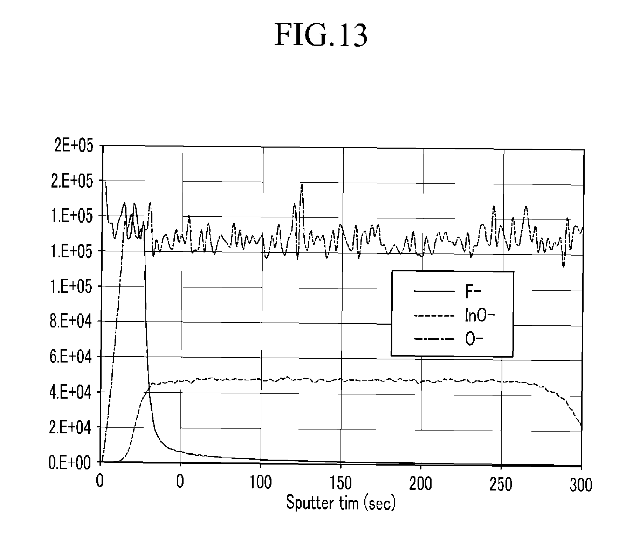

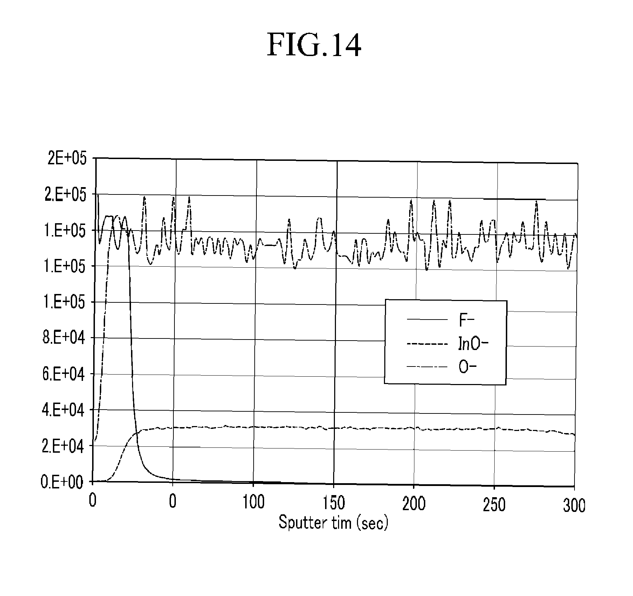

In addition, in the present Experimental Example, after the gas plasma processing using octa-fluoro-cyclo-butane (C₄F₈) and nitrogen trifluoride (NF₃) is performed, the results obtained by measuring the depth profile of fluorine, indium oxide, and oxygen of the semiconductor pattern are illustrated in FIGS. 13 and 14.

Referring to FIG. 12, as illustrated in FIG. 8, when the two exposed portions of the semiconductor pattern 132 are subjected to the first reduction processing, if the gas plasma processing using gas including hydrogen (H₂) is performed, the hydrogen gas is introduced into the upper layer of the exposed portion of the semiconductor pattern 132, such that the hydrogen concentration is high on the surface of the exposed portion of the semiconductor pattern 132. As such, the hydrogen gas is introduced into the upper layer of the exposed portion of the semiconductor pattern 132 to increase the carrier concentration of the exposed portion of the semiconductor pattern 132 and reduce the resistance, so that the exposed portion of the semiconductor pattern 132 has conductivity. Further, at the time of the gas plasma processing using gas including hydrogen, the metal component of the semiconductor material, for example, indium (In), and the like is precipitated on the surface of the exposed portion of the semiconductor pattern 132 , so that the exposed portion of the semiconductor pattern 132 has conductivity.

Next, referring to FIGS. 13 and 14, when the two exposed portions of the semiconductor pattern 132 are subjected to the first reduction processing as illustrated in FIG. 8, if the gas plasma processing using gas including fluorine (F) is performed, the concentration of fluorine (F) is increased and the concentration of oxygen is reduced on the surface of the exposed portion of the semiconductor pattern 132 for a short period of time after the plasma processing is performed. Therefore, the fluorine gas is introduced into the surface of the exposed portion of the semiconductor pattern 132 for an initial time of the plasma processing, and the oxygen within the semiconductor pattern 132 is reduced to increase the carrier concentration, so that the exposed portion of the semiconductor pattern 132 has conductivity.

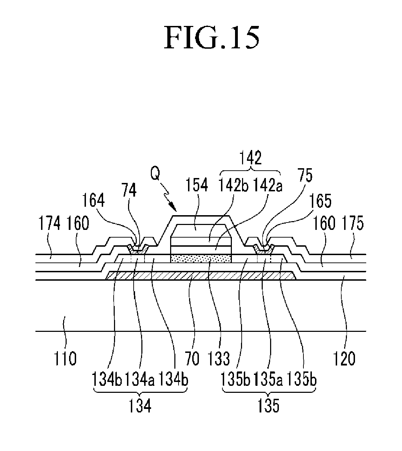

A thin film transistor array panel including a thin film transistor according to another embodiment of the present invention will be described with reference to FIG. 15. FIG. 15 is a cross-sectional view of a thin film transistor array panel including a thin film transistor according to another embodiment of the present invention.

Referring to FIG. 15, a thin film transistor and a thin film transistor array panel according to the embodiment of the present invention are similar to the thin film transistor and the thin film transistor array panel according to the embodiment illustrated in FIG. 1. The description of the same components will be omitted.

However, unlike the thin film transistor and the thin film transistor array panel according to the embodiment illustrated in FIG. 1, the thin film transistor and the thin film transistor array panel according to the embodiment of the present invention further includes a source conductor 74 disposed on the first source region 134a exposed through the first source contact hole 164 of the passivation layer 160 and a drain conductor 75 disposed on the first drain region 135a exposed through the first drain contact hole 165 of the passivation layer 160.

The source conductor 74 and the drain conductor 75 may be formed of a conductive metal layer to increase the conductivity of the first source region 134a and the first drain region 135a in order to reduce the resistance of the first source region 134a and the first drain region 135a.

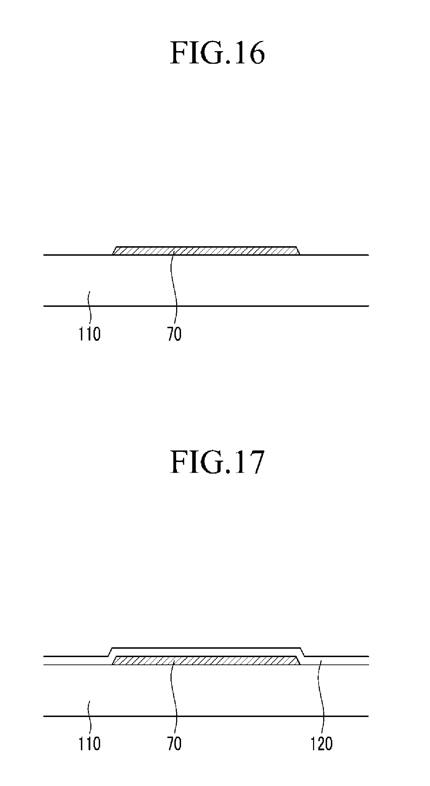

Next, a manufacturing method of a thin film transistor according to another embodiment of the present invention will be described with reference to FIGS. 16 to 30, along with FIG. 15. FIGS. 16 to 30 are cross-sectional views sequentially illustrating a manufacturing method of the thin film transistor array panel according to the embodiment illustrated in FIG. 15.

As illustrated in FIG. 16, the light blocking layer 70 including at least one of the organic insulating material, the inorganic insulating metal, and the conductive metal such as metal, and the like is formed on the insulating substrate 110. The forming of the light blocking layer 70 may be omitted according to the process conditions.

As illustrated in FIG. 17, the buffer layer 120 is formed on the light blocking layer 70.

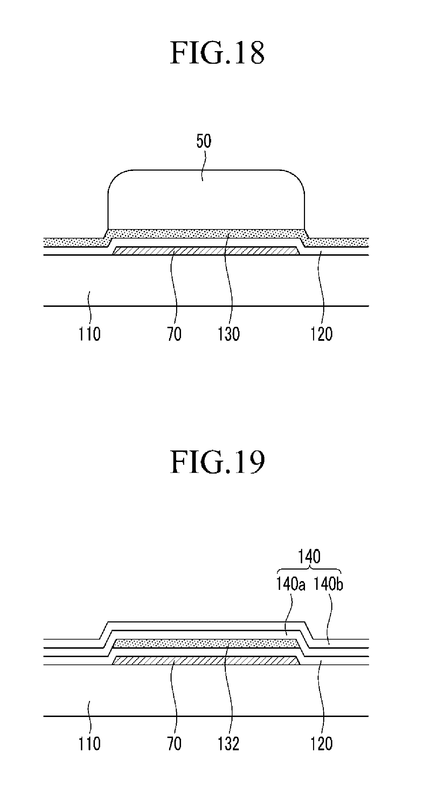

As illustrated in FIG. 18, the semiconductor layer 130 including the oxide semiconductor material may be deposited on the buffer layer 120. The semiconductor layer 130 may be deposited by a coating process or an ultra low-cost printing process.

Next, a photosensitive film such as a photoresist, and the like, is coated on the semiconductor layer 130 and is exposed to form the first photosensitive film pattern 50. The first photosensitive film pattern 50 may overlap at least a portion of the light blocking layer 70.

Next, the semiconductor layer 130 is etched using the first photosensitive film pattern 50 as a mask to form the semiconductor pattern 132 and then the first photosensitive film pattern 50 may be removed.

As illustrated in FIG. 19, the insulating material layer 140 is formed on the semiconductor pattern 132 and the buffer layer 120. The insulating material layer 140 may also be formed in a multilayer including the first layer 140a including the insulating oxide such as silicon oxide (SiOx), and the like, and the second layer 140b including the insulating material. However, the insulating material layer 140 may also be formed in a single layer including the insulating oxide such as silicon oxide (SiOx), and the like.

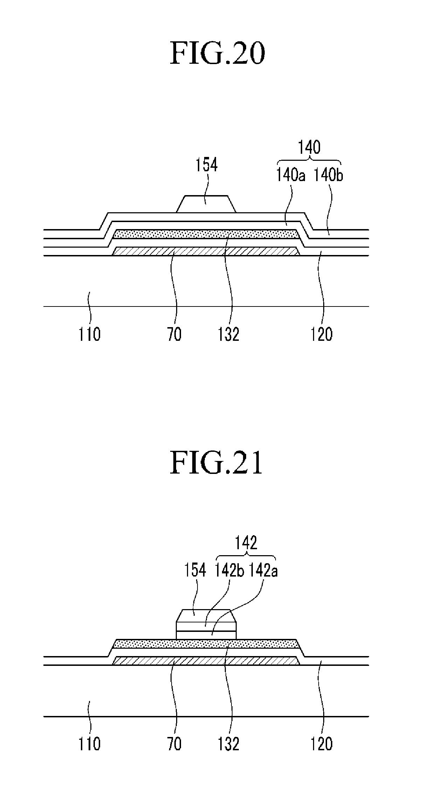

Next, referring to FIG. 20, the conductive material such as metal, and the like is deposited on the insulating material layer 140 and is patterned to form the gate electrode 154. The gate electrode 154 is formed on a portion of the semiconductor pattern 132 so that the two portions of the semiconductor pattern 132 disposed at both sides of the overlapping portion of the gate electrode 154 and the semiconductor pattern 132 are not covered with the gate electrode 154.

Next, as illustrated in FIG. 21, the insulating material layer 140 is patterned by using the gate electrode 154 as the etch mask to form the insulating layer 142. As a patterning method of the insulating material layer 140, a dry etching method may be used and the buffer layer 120 may not be etched by controlling etch gas and etch time. The insulating layer 142 may be formed in the first layer 142a including the insulating oxide and the second layer 142b including the insulating material. However, the insulating layer 142 may be formed in a single layer.

Therefore, the gate electrode 154 and the insulating layer 142 have substantially the same planar shape. Further, two portions of the semiconductor pattern 132 that are disposed at both sides of a portion of the overlapping portion of the gate electrode 154 and the semiconductor pattern 132, are not covered with the gate electrode 154. Accordingly, the two portions not covered with the gate electrode 154 are exposed.

According to the manufacturing method of the thin film transistor according to the embodiment of the present invention, the semiconductor pattern 132 and the gate electrode 154 are formed by different photolithography processes, but the semiconductor pattern 132, the insulating layer 142, and the gate electrode 154 may also be formed by performing the photolithography process once after sequentially depositing the semiconductor layer 130, the insulating material layer 140, and the gate electrode metal layer.

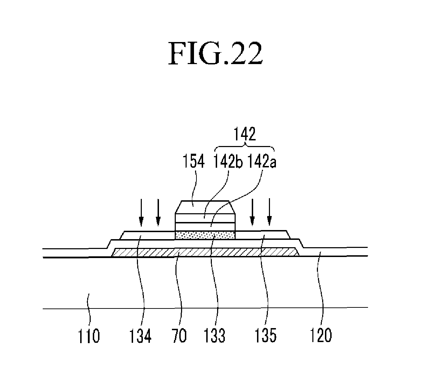

Next, referring to FIG. 22, the two exposed portions of the exposed semiconductor pattern 132 are subjected to first reduction processing to form the source electrode 134 and the drain electrode 135 having conductivity. In addition, the semiconductor pattern 132 that is covered with the insulating layer 142, and thus is not reduced, becomes the channel region 133.

As the reduction processing method of the exposed semiconductor pattern 132, the plasma processing using gas including hydrogen (H₂) such as hydrogen (H₂), phosphine (PH₃), ammonia (NH₃), silane (SiH₄), methane (CH₄), acetylene (C₂H₂), diborane (B₂H6), germane (GeH₄), hydrogen selenide (H₂Se), and hydrogen sulfide (H₂S) or gas plasma including fluorine (F) such as octa-fluoro-cyclo-butane (C₄F₈), nitrogen trifluoride (NF₃), and fluorine formaldehyde (CHF₃) may be used. At least a portion of the semiconductor material forming the exposed semiconductor pattern 132 that is subjected to the reduction processing is reduced, and thus only the metal bonding may remain. Therefore, the semiconductor pattern 132 that is subjected to the reduction processed has conductivity.

In more detail, when the gas plasma processing using gas including the hydrogen H₂ is performed, the hydrogen gas is introduced into the exposed portion of the semiconductor pattern 132 to increase carrier concentration and reduce sheet resistance Rs, such that the exposed portion of the semiconductor pattern 132 has conductivity. Further, at the time of the gas plasma processing using gas including hydrogen,a metal component of the semiconductor material, for example, indium (In), and the like is precipitated on the surface of the exposed portion of the semiconductor pattern 132, such that the exposed portion of the semiconductor pattern 132 has conductivity.

Further, when the gas plasma processing using gas including fluorine (F) is performed, the fluorine (F) is introduced into the surface of the exposed portion of the semiconductor pattern 132 to reduce the oxygen within the semiconductor pattern 132 and to increase the carrier concentration, such that the exposed portion of the semiconductor pattern 132 has conductivity.

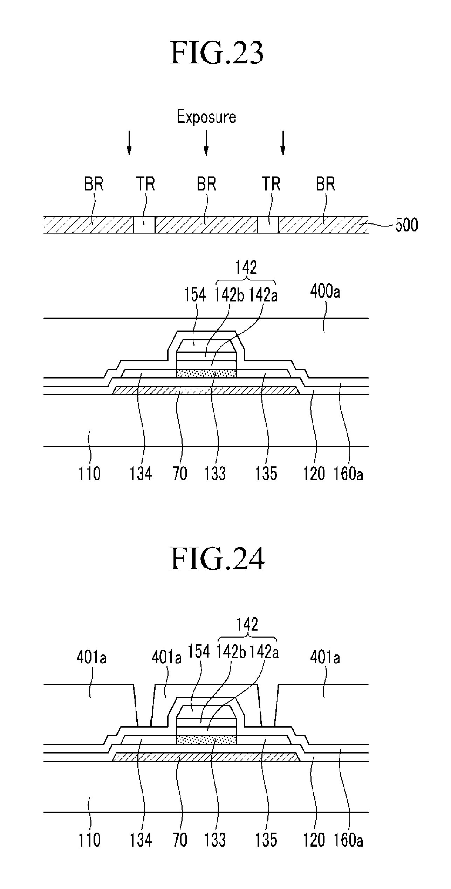

Next, as illustrated in FIG. 23, the insulating material is coated on the gate electrode 154, the source electrode 134, the drain electrode 135, and the buffer layer 120 to deposit the passivation layer 160a. In this case, a first photosensitive film 400a is deposited on the passivation layer 160a and is exposed using a photo mask 500. The photo mask 500 has a light blocking region (BR) and a light transmitting region (TR). The light transmitting region (TR) of the photo mask 500 corresponds to a position at which the first source contact hole 164 and the first drain contact hole 165 are to be formed in the passivation layer 160a, and the first photosensitive film 400a is a positive photosensitive film.

As illustrated in FIG. 24, after a first photosensitive film 400a is exposed and developed, a first photosensitive film pattern 401a with the removed first photosensitive film 400a is formed in the region corresponding to a position at which the first source contact hole 164 and the first drain contact hole 165 are formed.

An embodiment of the present invention discloses that the first photosensitive film 400a is the positive photosensitive film and the light transmitting region (TR) of the photo mask 500 corresponds to a position at which the first source contact hole 164 and the first drain contact hole 165 are formed in the passivation layer 160 but, according to the thin film transistor and the manufacturing method of the thin film transistor array panel according to another embodiment of the present invention, the first photosensitive film 400a may be a negative photosensitive film and a light blocking region (BR) of the photo mask 500 may also correspond to a position at which the first source contact hole 164 and the first drain contact hole 165 are formed in the passivation layer 160.

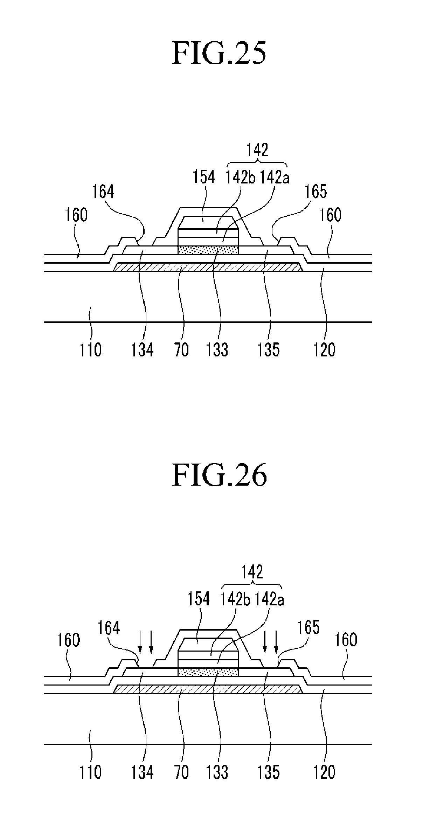

Next, the passivation layer 160 is etched by using the first photosensitive film pattern 401a as an etch mask and the remaining first photosensitive film pattern 401a is removed, thereby forming the first source contact hole 164 exposing the source electrode 134 and the first drain contact hole 165 exposing the drain electrode 135 in the passivation layer 160, as illustrated in FIG. 25. In this case, the exposed portion of the source electrode 134 and the drain electrode 135 through the first source contact hole 164 and the first drain contact hole 165 contact an etchant, etch gas, or oxygen in the air, such that at least a part thereof may be oxidized again. In this case, the oxidized region may have low charge mobility.

Next, as illustrated in FIG. 26, the exposed portions of the source electrode 134 and the drain electrode 135 through the first source contact hole 164 and the first drain contact hole 165 are again subjected to the second reduction processing, and thus are oxidized, such that the charge mobility of the region having lower charge mobility than that of the circumference thereof may be equal to or greater than that of the circumference thereof. For example, the charge mobility of the first drain region 135a may be greater than or equal to 1x10¹⁹ and the charge mobility of the second drain region 135b may be less than or equal to 1x10¹⁷.

Therefore, as illustrated in FIG. 15, the portion of the source electrode 134 disposed around the first source region 134a disposed at the exposed portion by the first source contact hole 164 becomes the second source region 134b and the portion of the drain electrode 135 disposed around the first drain region 135a disposed at the exposed portion by the first drain contact hole 165 becomes the second drain region 135b. The first source region 134a and the first drain region 135a are subjected to the first reduction processing to have conductivity; then partially oxidized; and then subjected to the second reduction processing again, so that the first source region 134a and the first drain region 135a may have the charge mobility equal to or greater than that of the second source region 134b and second drain region 135b. For example, the charge mobility of the first drain region 135a may be greater than or equal to 1x10¹⁷ or more and the charge mobility of the second drain region 135b may be less than or equal to 1x10¹⁷.

According to a manufacturing method of the thin film transistor array panel according to another embodiment of the present invention, as illustrated in FIGS. 23 to 25, the patterning of the passivation layer 160 for forming the first source contact hole 164 exposing the source electrode 134 and the first drain contact hole 165 exposing the drain electrode 135 and the second reduction processing illustrated in FIG. 26 may be performed simultaneously. In this case, the first source region 134a and the first drain region 135a are subjected to the first reduction processing to have conductivity and then are subjected to the second reduction processing again, such that the charge mobility of the first source region 134a and the first drain region 135a may be greater than that of the second source region 134b and the second drain region 135b.

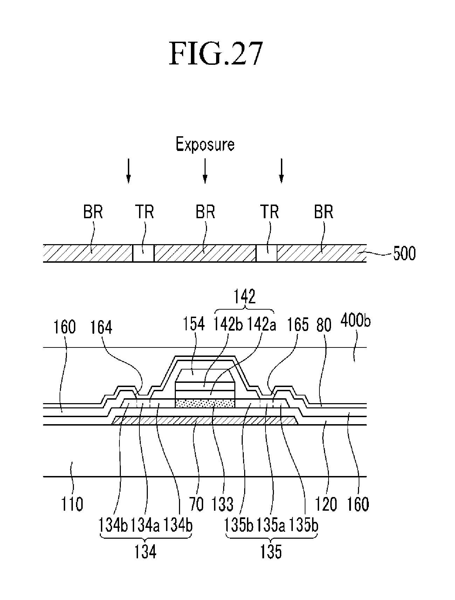

Referring to FIG. 27, a metal layer 80 is deposited on the passivation layer 160 and the first source region 134a and the first drain region 135a of the source electrode 134 and the drain electrode 135 exposed through the first source contact hole 164 and the first drain contact hole 165, and a second photosensitive film 400b is deposited thereon. Next, the second photosensitive film 400b is exposed through using the photo mask 500 used during the process of forming the first source contact hole 164 and the first drain contact hole 165 by patterning the passivation layer 160 described above with reference to FIGS. 23 to 25. Herein, the second photosensitive film 400b is a negative photosensitive film 400b and the light transmitting region (TR) of the photo mask 500 is a region corresponding to the first source contact hole 164 and the first drain contact hole 165. That is, characteristics of the photosensitive film of the second photosensitive film 400b are opposite to characteristics of the photosensitive film of the first photosensitive film 400a described in FIG. 23.

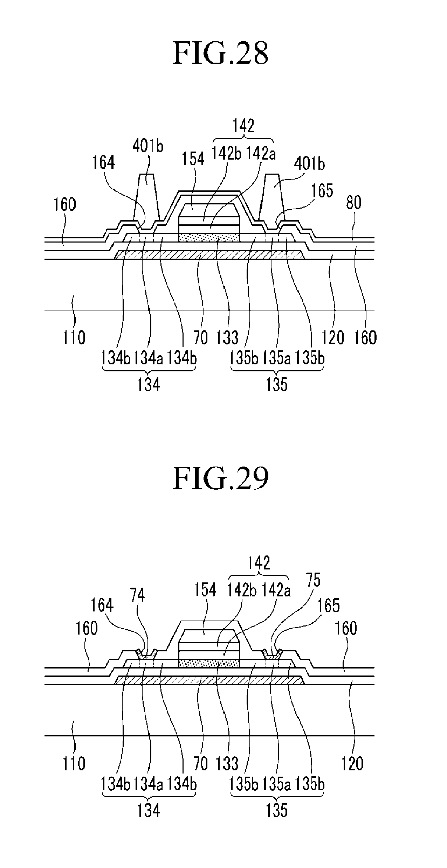

As illustrated in FIG. 28, after the second photosensitive film 400b is exposed and developed, a second photosensitive film pattern 401b is formed so that the second photosensitive film 400b is disposed only in the region corresponding to a position at which the first source contact hole 164 and the first drain contact hole 165 are formed.

In this embodiment of the present invention, the first photosensitive film 400a is the positive photosensitive film, the second photosensitive film 400b is a negative photosensitive film, and the light transmitting region (TR) of the photo mask 500 corresponds to the first source contact hole 164 and the first drain contact hole 165, but according to the manufacturing method of the thin film transistor and the thin film transistor array panel according to another embodiment of the present invention, the first photosensitive film 400a may be the negative photosensitive film, the second photosensitive film 400b may be the positive photosensitive film, and the light blocking region (BR) of the photo mask 500 may also correspond to a position at which the first source contact hole 164 and the first drain contact hole 165 are formed.

Next, the metal layer 80 is etched using the second photosensitive film pattern 401b as the etch mask and the remaining second photosensitive film pattern 401b is removed, thereby forming the source conductor 74 disposed on the first source region 134a exposed through the first source contact hole 164 of the passivation layer 160 and the drain conductor 75 disposed on the first drain region 135a exposed through the first drain contact hole 165 of the passivation layer 160, as illustrated in FIG. 29.

As described above, according to the manufacturing method of the thin film transistor and the thin film transistor array panel according to the embodiment of the present invention, the process of forming the first source contact hole 164 and the first drain contact hole 165 in the passivation layer 160, and the process of forming the source conductor 74 and the drain conductor 75 use one photo mask 500 the first photosensitive film 400a and the second photosensitive film 400b having different photosenstivities. Therefore, even though the photolithography process of forming the source conductor 74 and the drain conductor 75 is added, one photo mask is used, thereby preventing the manufacturing costs from increasing.

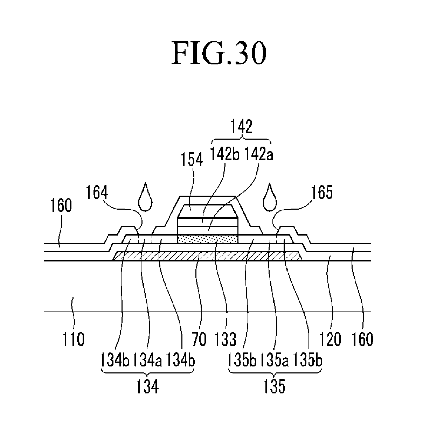

FIG. 30 illustrates another method of forming the source conductor 74 and the drain conductor 75. Referring to FIG. 30, drops of a conductive liquid material are deposited on the first source region 134a exposed through the first source contact hole 164 and the first drain region 135a exposed through the first drain contact hole 165 using a liquid process, such as inkjet, without using the photolithography process. The conductive liquid material is then cured, thereby forming the source conductor 74 and the drain conductor 75.

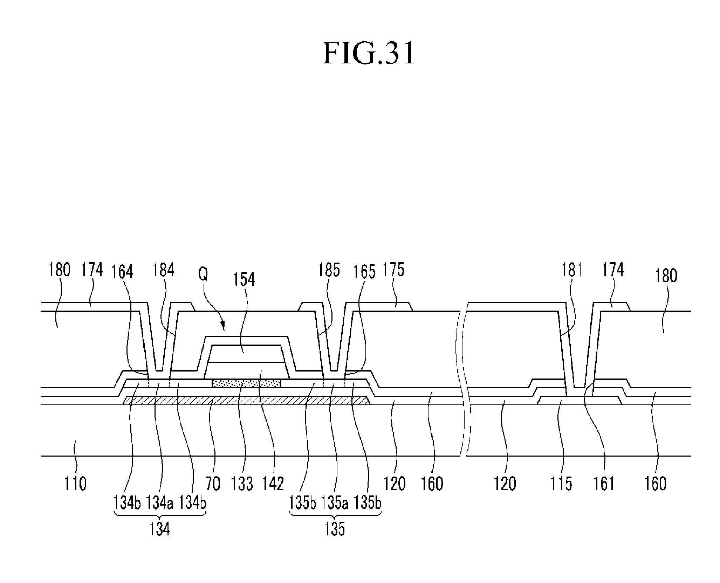

Next, the thin film transistor and the thin film transistor array panel according to another embodiment of the present invention will be described with reference to FIG. 31. The same components as the foregoing embodiments are denoted by reference numerals and the same description thereof will be omitted and only the differences therebetween will be described.

FIG. 31 is a cross-sectional view of a thin film transistor array panel including a thin film transistor according to another embodiment of the present invention.

Referring to FIG. 31, the light blocking layer 70 may be disposed on the insulating substrate 110. The description of the light blocking layer 70 is the same as the foregoing embodiments, and therefore will be omitted.

A data line 115 transferring a data signal is disposed on the insulating substrate 110. The data line 115 may be formed of conductive materials of metals such as aluminum (Al), silver (Ag), copper (Cu), molybdenum (Mo), chromium (Cr), tantalum (Ta), titanium (Ti), and the like, and an alloy thereof.

The buffer layer 120 is disposed on the light blocking layer 70 and the data line 115.

The description of the buffer layer 120 is the same as the foregoing embodiments, and therefore will be omitted.

The channel region 133, the source electrode 134, and the drain electrode 135 are disposed on the buffer layer 120.

The channel region 133 may be formed of an oxide semiconductor material. When the light blocking layer 70 is present, the channel region 133 may be covered with the light blocking layer 70.

The source electrode 134 and the drain electrode 135 are each disposed to face each other at both sides, centered on the channel region 133, and are separated from each other. Further, the source electrode 134 and the drain electrode 135 are connected to the channel region 133.

The source electrode 134 and the drain electrode 135 have conductivity and include the same material as the semiconductor material forming the channel region 133 and the reduced semiconductor material. Metals such as indium (In), and the like, which are included in the semiconductor material, may be precipitated on the surfaces of the source electrode 134 and the drain electrode 135.

The source electrode 134 includes the first source region 134a and the second source region 134b that is the portion disposed around the first source region 134a. The drain electrode 135 also includes the first drain region 135a and the second drain region 135b that is the portion disposed around the first drain region 135a. The charge mobility of the first source region 134a is equal to or greater than that of the second source region 134b and the charge mobility of the first drain region 135a is equal to or greater than that of the second drain region 135b. For example, the charge mobility of the first drain region 135a may be about 1x10¹⁷ or more and the charge mobility of the second drain region 135b may be about 1x10¹⁷ or less.

The first source region 134a of the source electrode 134 is disposed under a second source contact hole 184 to be described below and the planar shape thereof coincides with an edge of the second source contact hole 184. Similarly thereto, the first drain region 135a of the drain electrode 135 is disposed under a second drain contact hole 185 to be described below and the planar shape thereof coincides with an edge of the second drain contact hole 185.

The first source region 134a of the source electrode 134 is electrically connected to the data line 115. This will be described below in more detail.

The insulating layer 142 is disposed on the channel region 133. The insulating layer 142 may cover the channel region 133. Further, the insulating layer 142 may barely overlap the source electrode 134 or the drain electrode 135. The insulating layer 142 may be a single layer or a multilayer as in the foregoing embodiment.

The gate electrode 154 is disposed on the insulating layer 142. Edges of the gate electrode 154 and edges of the insulating layer 142 may be substantially aligned so as to coincide with each other.

The gate electrode 154 includes a portion overlapping the channel region, 133 and the channel region 133 is covered with the gate electrode 154. The source electrode 134 and the drain electrode 135 are disposed at both sides of the channel region 133, centered on the gate electrode 154, and the source electrode 134 and the drain electrode 135 may not substantially overlap the gate electrode 154. Therefore, the parasitic capacitance between the gate electrode 154 and the source electrode 134, or the parasitic capacitance between the gate electrode 154 and the drain electrode 135, may be very small.

The gate electrode 154, the source electrode 134, and the drain electrode 135 form the thin film transistor Q along with the channel region 133.

The passivation layer 160 is formed on the gate electrode 154, the source electrode 134, the drain electrode 135, and the buffer layer 120. As described above, the passivation layer 160 has the first source contact hole 164 and the first drain contact hole 165 and the passivation layer 160 and the buffer layer 120 have the first contact hole 161 exposing the data line 115.

An organic layer 180 is further disposed on the passivation layer 180. The organic layer 180 may include the organic insulating material or the color filter material. A surface of the organic layer 180 may be planarized. The organic layer 180 has the second source contact hole 184 exposing the source electrode 134 to correspond to the first source contact hole 164 of the passivation layer 160, the second drain contact hole 185 exposing the drain electrode 135 to correspond to the first drain contact hole 165 of the passivation layer 160, and the second contact hole 181 exposing the data line 115 to correspond to the first contact hole 161 of the passivation layer 160 and the buffer layer 120.

The portion exposed through the first source contact hole 164 and the second source contact hole 184 in the source electrode 134 is the first source region 134a and the portion exposed through the first drain contact hole 165 and the second drain contact hole 185 in the drain electrode 135 is the first drain region 135a.

FIG. 31 illustrates edges of the contact holes 184, 185, and 181 of the organic layer 180 each coinciding with the edges of the contact holes 164, 165, and 161 of the passivation layer 160, but unlike this, the contact holes 164, 165, and 161 of the passivation layer 160 may be disposed in the contact holes 184, 185, and 181 of the organic layer 180. That is, the contact holes 164, 165, and 161 of the passivation layer 160 may be disposed in the edges of the contact holes 184, 185, and 181 of the organic layer 180.

The data input electrode 174 and the data output electrode 175 may be disposed on the organic layer 180. The data input electrode 174 may be electrically connected to the first source region 134a in the source electrode 134 of the thin film transistor Q through the first source contact hole 164 of the passivation layer 160 and the second source contact hole 184 of the organic layer 180 and the data output electrode 175 may be electrically connected to the first drain region 135a in the drain electrode 135 of the thin film transistor Q through the first drain contact hole 165 of the passivation layer 160 and the second drain contact hole 185 of the organic layer 180. In addition, the data input electrode 174 may be connected to the data line 115 through the first contact hole 161 of the passivation layer 160 and the second contact hole 181 of the organic layer 180. Therefore, the source electrode 134 may receive the data signal from the data line 115. The data output electrode 175 itself may form the pixel electrode to control the image display and may be connected to a separate pixel electrode (not illustrated).

As described above, according to the thin film transistor array panel according to the embodiment of the present invention, the data input electrode 174 is connected to the first source region 134a equal to or larger than that of other regions in the source electrode 134, and the data output electrode 175 is connected to the first drain region 135a equal to or larger than that of other regions in the drain electrode 135, such that the data input electrode 174 may be more securely electrically connected to the source electrode 134 and the data output electrode 175 may be more securely electrically connected to the drain electrode 135. Further, the source electrode 134 and the drain electrode 135 are disposed at both sides of the channel region 133, centered on the gate electrode 154, and the source electrode 134 and the drain electrode 135 do not substantially overlap the gate electrode 154. Therefore, the parasitic capacitance between the gate electrode 154 and the source electrode 134 or the parasitic capacitance between the gate electrode 154 and the drain electrode 135 may be very small.

Although not illustrated, according to a thin film transistor array panel according to another embodiment of the present invention, similar to the embodiment illustrated in FIG. 15, the thin film transistor array panel may further include the source conductor 74 and the drain conductor 75 that are formed on the first source region 134a and the first drain region 135a.

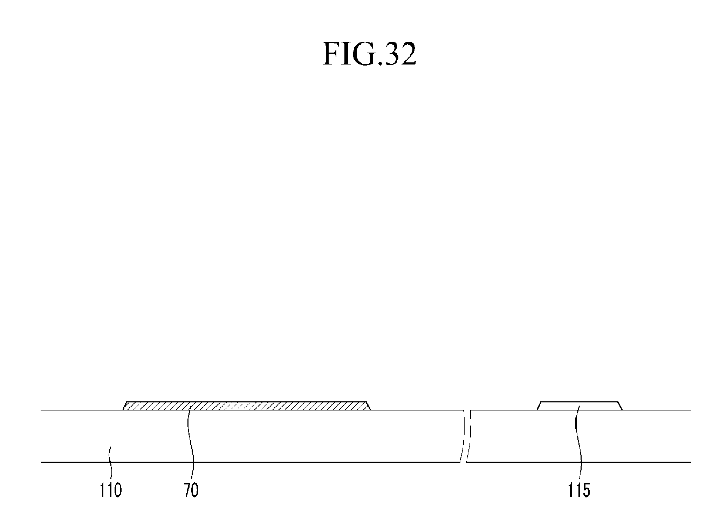

Next, a manufacturing method of a thin film transistor array panel according to another embodiment of the present invention will be described with reference to FIGS. 32 to 41 along with FIG. 31.

FIGS. 32 to 41 are cross-sectional views sequentially illustrating a manufacturing method of the thin film transistor array panel illustrated in FIG. 31. The manufacturing method of the thin film transistor according to the embodiment of the present invention is similar to the manufacturing method of the thin film transistor according to the embodiment described with reference to FIGS. 2 to 8 and FIGS. 10 and 11. Therefore, the detailed description of like components will be omitted.

Referring to FIG. 32, the light blocking layer 70 formed of the organic insulating material, the inorganic insulating material, and the conductive material such as metal, and the like, is formed on the insulating substrate 110 that may be formed of glass, plastic, and the like. The forming of the light blocking layer 70 may be omitted according to the process conditions.

Next, metal, and the like is deposited and patterned on the insulating substrate 110 to form the data line 115. The formation order of the light blocking layer 70 and the data line 115 may be changed.

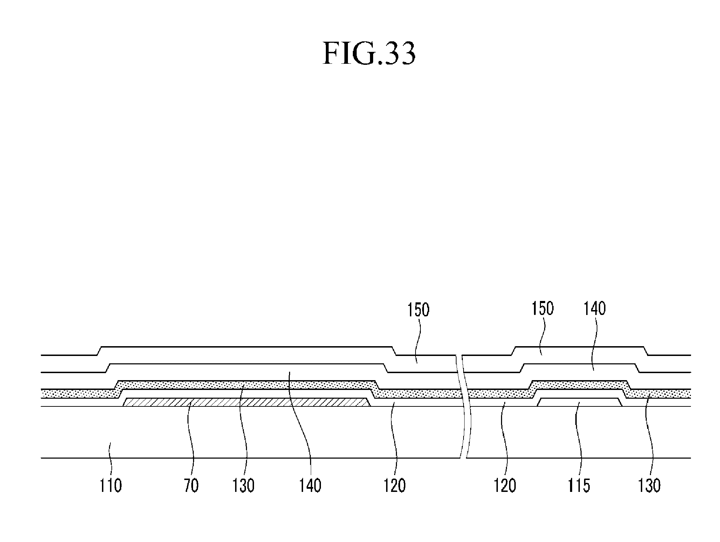

Next, as illustrated in FIG. 33, the buffer layer 120, the semiconductor layer 130, the insulating material layer 140, and the gate layer 150 are sequentially deposited on the light blocking layer 70 and the data line 115.

The buffer layer 120 may be formed by depositing insulating oxide, for example, an insulating material including at least one insulating oxide of silicon oxide (SiOx), aluminum oxide (Al₂O₃), hafnium oxide (HfO₃), and yttrium oxide (Y₂O₃).

The semiconductor layer 130 may be formed by depositing oxide semiconductor including at least one of metals, such as zinc (Zn), indium (In), gallium (Ga), tin (Sn), titanium (Ti), and the like, for example, an oxide semiconductor material such as zinc oxide (ZnO), zinc-tin oxide (ZTO), zinc-indium oxide (ZIO), indium oxide (InO), titanium oxide (TiO), indium-gallium-zinc oixe (IGZO), indium-zinc-tin oxide (IZTO), and the like. The semiconductor layer 130 may be deposited by a coating process or an ultra low-cost printing process.

The insulating material layer 140 may also be formed of an insulating material including the insulating oxide such as silicon oxide (SiOx), and the like. The insulating material layer 140 may also be formed in a single layer or a multilayer including the first layer 140a including oxide such as silicon oxide (SiOx), and the like, and the second layer 140b including the insulating material.

The gate layer 150 may be formed by depositing a conductive material such as aluminum (Al), and the like.

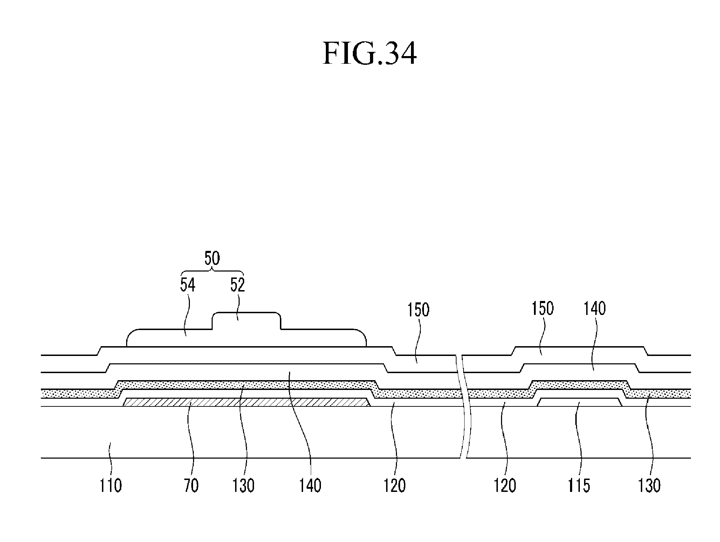

Next, as illustrated in FIG. 34, the photosensitive film, such as the photo resist, is coated on the gate layer 150 and is exposed to form a second photosensitive film pattern 50. As illustrated in FIG. 34, the second photosensitive film pattern 50 includes a first portion 52 having a relatively thick thickness and a second portion 54 having a relatively thin thickness. The first portion 52 of the second photosensitive film pattern 50 may be disposed at a position overlapping the light blocking layer 70. Further, both sides of the first portion 52 of the second photosensitive film pattern 50 are connected to a pair of the second portions 54 that are separated from each other based on the first portion 52 to face each other.

As described above, the second photosensitive film pattern 50 having different thicknesses may be formed by being exposed through the photo mask (not illustrated) including a transflective region. In detail, the photo mask for forming the second photosensitive film pattern 50 may include a transmitting region transmitting light, a light blocking region blocking light, and a transflective region transmitting only a portion of light. The transflective region may be formed using a slit, a transflective film, and the like.

When the exposure is made using the photo mask including the transflective region, in the case of using the negative photosensitive film, a portion corresponding to the transmitting region of the photo mask is irradiated with light, and thus the photosensitive film remains, such that the first portion 52 having a relatively large thickness is formed, and a portion corresponding to the light blocking region of the photo mask is not irradiated with light, and thus the photosensitive film is removed and a portion corresponding to the transflective region of the photo mask is partially irradiated with light, such that the second portion 54 having a relatively small thickness is formed. The case of using the positive photosensitive film is opposite that of the foregoing case, but the portion corresponding to the transflective region of the photo mask is still irradiated with a portion of light to form the second portion 54.

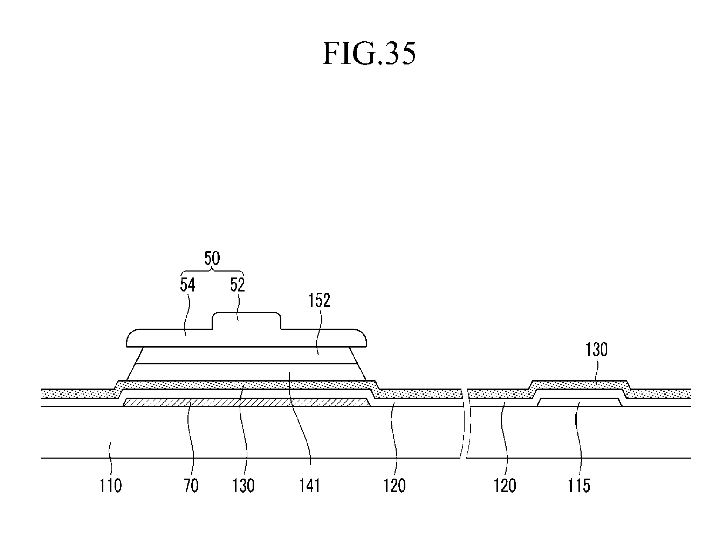

Referring to FIGS. 34 and 35, the gate layer 150 and the insulating material layer 140 are sequentially etched by using the second photosensitive film pattern 50 as the etch mask. In this case, the gate layer 150 may be etched using a wet etching method and the insulating material layer 140 may be etched using a dry etching method.

Therefore, the gate pattern 152 and the insulating pattern 141 having the same planar shape may be formed under the second photosensitive film pattern 50. The semiconductor layer 130 that is not covered with the second photosensitive film pattern 50 may be exposed.

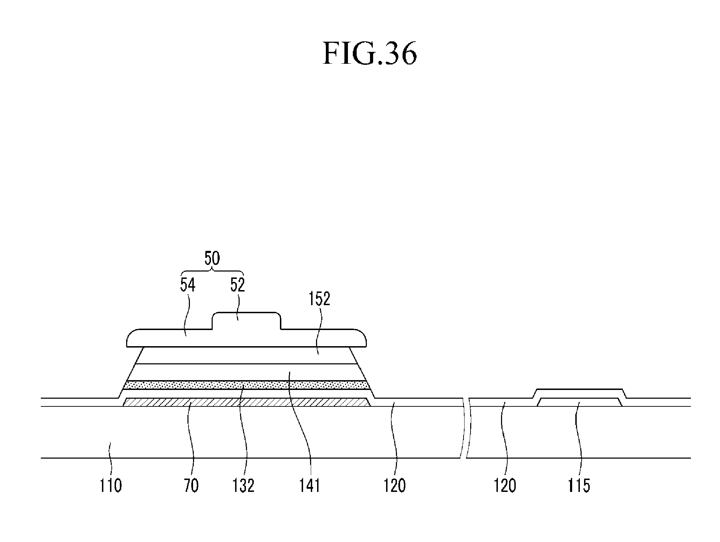

Next, as illustrated in FIG. 36, the exposed semiconductor layer 130 is etched by using the gate pattern 152 and the insulating pattern 141 as the etch mask to form the semiconductor pattern 132. The semiconductor pattern 132 may have the same planar shape as the gate pattern 152 and the insulating pattern 141.

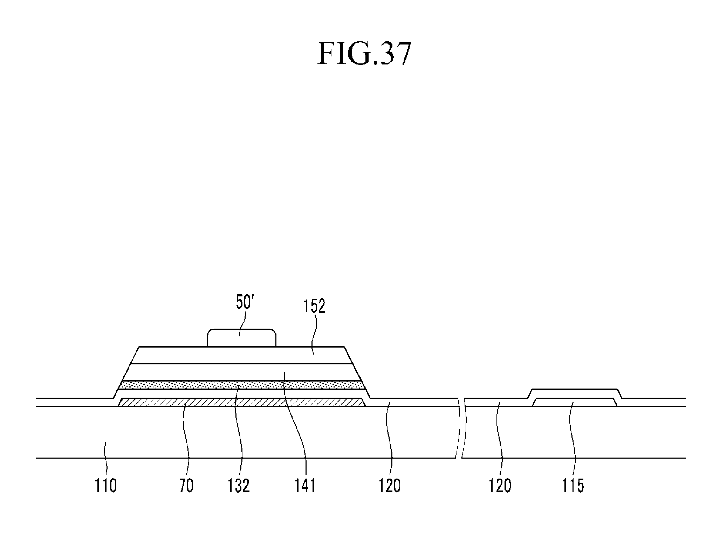

Thereafter, as illustrated in FIG. 37, the second photosensitive film pattern 50 is ashed to reduce its thickness, thereby removing the second portion 54. By doing so, the first portion 52 with the reduced thickness remains to form a third photosensitive film pattern 50'.

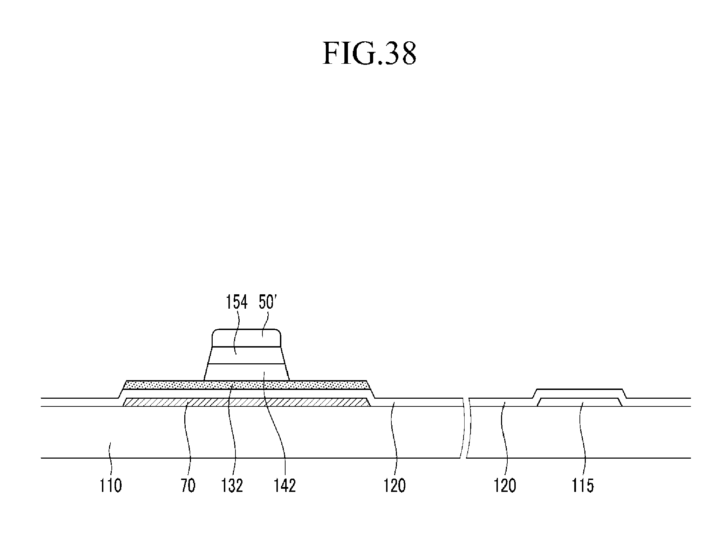

Next, referring to FIG. 38, the gate pattern 152 and the insulating pattern 141 are sequentially etched by using the third photosensitive film pattern 50' as the etch mask. Therefore, the semiconductor pattern 132 that is not covered with the third photosensitive film pattern 50' is exposed. The exposed portion portions of the semiconductor pattern 132 are disposed at both sides with respect to the semiconductor pattern 132 covered with the third photosensitive film pattern 50' and are separated from each other.

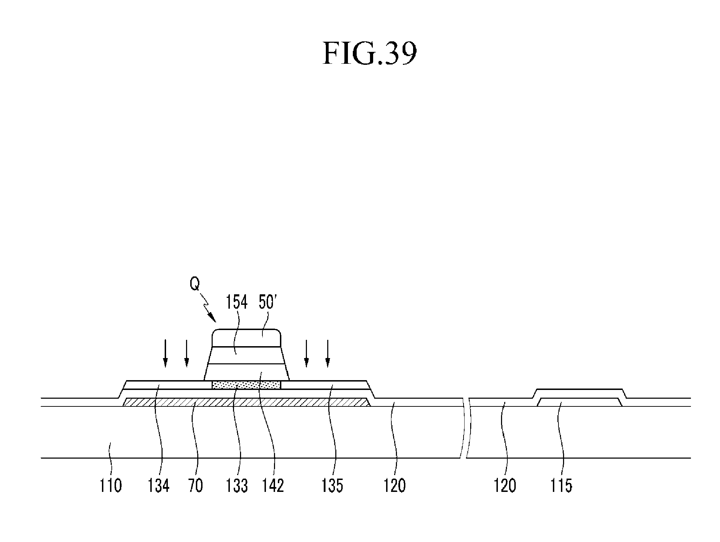

Referring to FIG. 39, the exposed portion of the semiconductor pattern 132 is subjected to first reduction processing to form the source electrode 134 and the drain electrode 135 having conductivity. In this case, the portion of the semiconductor pattern 132 that is covered with the insulating layer 142, and thus is not reduced, becomes the channel region 133. The gate electrode 154, the source electrode 134, and the drain electrode 135 form the thin film transistor Q along with the channel region 133.

As the reduction processing method of the exposed portion of the semiconductor pattern 132, plasma processing using gas including hydrogen (H₂) such as hydrogen (H₂), phosphine (PH₃), ammonia (NH₃), silane (SiH₄), methane (CH4), acetylene (C₂H₂), diborane (B₂H₆), germane (GeH₄), hydrogen selenide (H₂Se), and hydrogen sulfide (H₂S) or gas plasma including fluorine (F) such as octa-fluoro-cyclo-butane (C₄F₈), nitrogen trifluoride (NF₃), and fluorine formaldehyde (CHF₃) may be used. At least a portion of the semiconductor material forming the exposed portion of the semiconductor pattern 132 that is subjected to the reduction processing is reduced, and thus only the metal bonding may remain. Therefore, the exposed portion of the semiconductor pattern 132 that is subjected to the reduction processing has conductivity.

In more detail, when the gas plasma processing using gas including the hydrogen H₂ is performed, the hydrogen gas is introduced into the exposed portion of the semiconductor pattern 132 to increase carrier concentration and reduce sheet resistance Rs, such that the exposed portion of the semiconductor pattern 132 has conductivity. Further, at the time of the gas plasma processing using gas including hydrogen, a metal component of the semiconductor material, for example, indium (In), and the like is precipitated on the surface of the exposed portion of the semiconductor pattern 132, such that the exposed portion of the semiconductor pattern 132 has conductivity.

Further, when the gas plasma processing using gas including fluorine (F) is performed, the fluorine (F) is introduced into the surface of the exposed portion of the semiconductor pattern 132 to reduce that oxygen within the semiconductor pattern 132 to increase the carrier concentration, such that the exposed portion of the semiconductor pattern 132 has conductivity.

At the time of the reduction processing of the exposed portion of the semiconductor pattern 132, a metal component of the semiconductor material, for example, indium (In), and the like may be precipitated on the surface of the exposed portion of the semiconductor pattern 132. The thickness of the precipitated metal layer may be set to be 200 nm or less.

According to the embodiment of the present invention, the boundary between the channel region 133 and the source electrode 134 or the boundary between the channel region 133 and the drain electrode 135 may be substantially aligned to coincide with the edges of the gate electrode 154 and the insulating layer 142. However, at the time of the reduction processing of the exposed portion of the semiconductor pattern 132, the semiconductor pattern 132 under the edge portion of the insulating layer 142 may be reduced to some extent, such that the boundary between the channel region 133 and the source electrode 134 or the drain electrode 135 may be disposed more inwardly from the edges of the gate electrode 154 and the insulating layer 142.

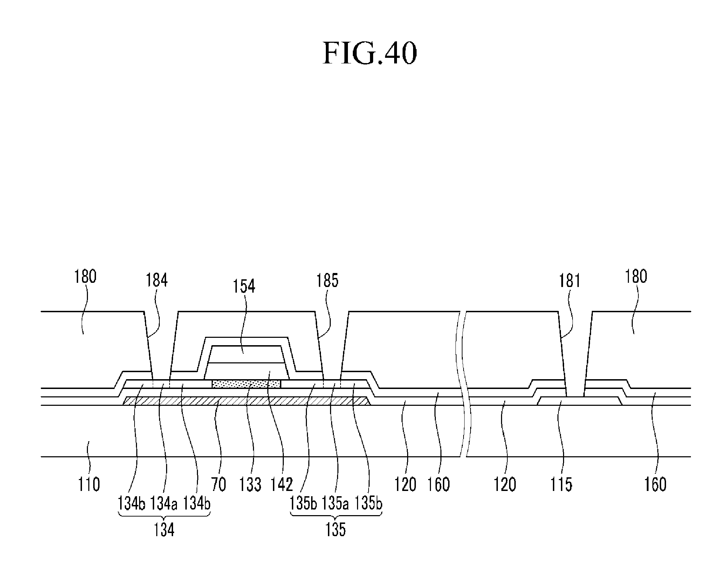

Next, referring to FIG. 40, after the photosensitive film pattern 50' is removed, the insulating material is coated on the gate electrode 154, the source electrode 134, the drain electrode 135, and the buffer layer 120 to form the passivation layer 160. Next, the organic insulating material is coated on the passivation layer 160 to further form the organic layer 180. In this case, the first source contact hole 164 exposing the position at which the first source region 134a of the source electrode 134 is formed, the first drain contact hole 165 exposing the position at which the first drain region 135a of the drain electrode 135 is formed, and the first contact hole 161 exposing a portion of the data line 115 are formed in the passivation layer 160.

Further, the second source contact hole 184 exposing the position at which the first source region 134a of the source electrode 134 is formed, the second drain contact hole 185 exposing the position at which the first drain region 135a of the drain electrode 135 is formed, and the second contact hole 181 exposing a portion of the data line 115 are formed in the organic layer 180.

FIG. 40 illustrates that the edges of the contact holes 184, 185, and 181 of the organic layer 180 each coincide with the edges of the contact holes 164, 165, and 161 of the passivation layer 160, and the contact holes 164, 165, and 161 of the passivation layer 160 may be disposed in the edges of the contact holes 184, 185, and 181 of the organic layer 180.

Further, the contact holes 184, 185, and 181 of the organic layer 180 and the contact holes 164, 165, and 161 of the passivation layer 160 may also be formed simultaneously. In this case, the exposed portion of the source electrode 134 and the drain electrode 135 through the contact holes 184 and 185 of the organic layer 180 and the contact holes 164 and 165 of the passivation layer 160 contact an etchant, etch gas, or oxygen in the air, such that at least a portion thereof may be oxidized again.

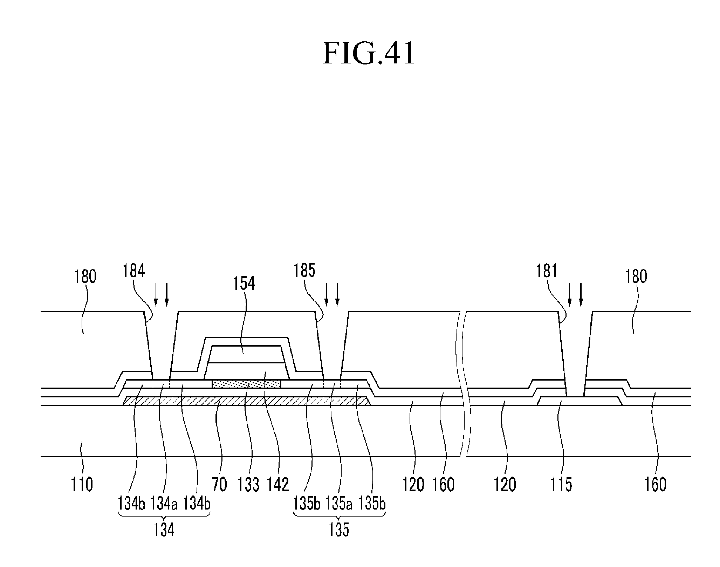

Next, as illustrated in FIG. 41, a portion of the source electrode 134 and a portion of the drain electrode 135 that are exposed by the contact holes 184 and 185 of the organic layer 180 and the contact holes 164 and 165 of the passivation layer 160 are subjected to the second reduction processing to form the first source region 134a and the first drain region 135a having the charge mobility equal to or greater than that that of the circumference thereof.

The portion of the source electrode 134 disposed around the first source region 134a disposed at the exposed part by the first source contact hole 164 becomes the second source region 134b and the portion of the drain electrode 135 disposed around the first drain region 135a disposed at the exposed portion by the first drain contact hole 165 becomes the second drain region 135b. The first source region 134a and the first drain region 135a are subjected to the first reduction processing to have conductivity and then are partially oxidized and are subjected to the second reduction processing again, such that the charge mobility of the first source region 134a and the first drain region 135a may be greater than that of the remaining second source region 134b and second drain region 135b.

According to a manufacturing method of the thin film transistor array panel according to another embodiment of the present invention, the passivation layer 160 and the organic layer 180 illustrated in FIG. 40 may be patterned to simultaneously perform the process of forming the first source contact holes 184 and 185 of the organic layer 180 and the contact holes 164 and 165 of the passivation layer 160 and the process of performing the second reduction processing illustrated in FIG. 41. In this case, the first source region 134a and the first drain region 135a are subjected to the first reduction processing to have conductivity and then are subjected to the second reduction processing again, such that the charge mobility of the first source region 134a and the first drain region 135a may be greater than that of the second source region 134b and the second drain region 135b. For example, the charge mobility of the first drain region 135a may be about 1x10¹⁷ or more and the charge mobility of the second drain region 135b may be about 1x10¹⁷ or less.

Further, the manufacturing method of the thin film transistor array panel according to another embodiment of the present invention may further include a process of forming the source conductor 74 disposed on the first source region 134a exposed by the first source contact hole 164 of the passivation layer 160 and the drain conductor 75 disposed on the first drain region 135a exposed by the first drain contact hole 165 of the passivation layer 160, by using the same photo mask as the photo mask used during the process of patterning the passivation layer 160 and the organic layer 180 to form the contact holes 184 and 185 of the organic layer 180 and the contact holes 164 and 165 of the passivation layer 160. Alternatively, the manufacturing method of the thin film transistor array panel may further include a process of dropping and curing the conductive liquid material on the first source region 134a exposed by the first source contact hole 164 and the first drain region 135a exposed by the first drain contact hole 165 to form the source conductor 74 and the drain conductor 75.

Finally, as illustrated in FIG. 31, the data input electrode 174 and the data output electrode 175 may be formed on the organic layer 180, such that the data input electrode 174 is connected to the first source region 134a of the source electrode 134 and the data output electrode 175 is connected to the first drain region 135a of the drain electrode 135.

Simultaneously, the data input electrode 174 is connected to the data line 115 that is exposed through the first contact hole 161 formed in the passivation layer 160 and the second contact hole 181 formed in the organic layer 180.

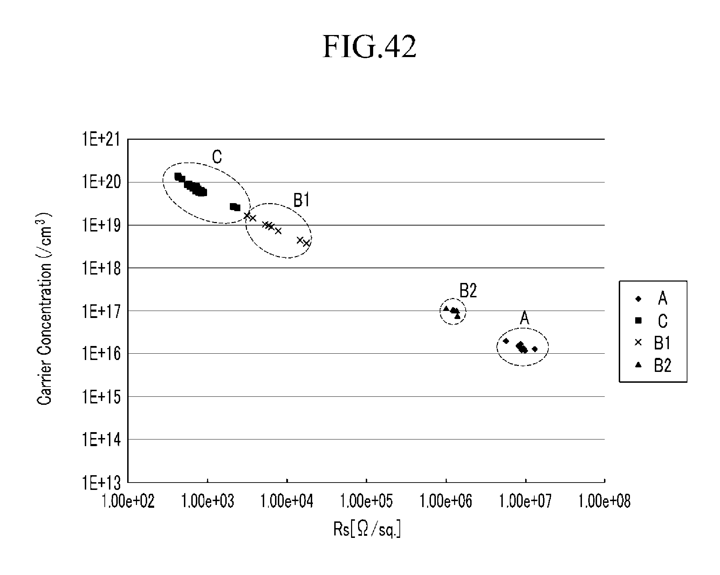

Next, one Experimental Example of the present invention will be described with reference to FIG 42. In the present Experimental Example, while manufacturing the thin film transistor and the thin film transistor array panel according to the thin film transistor, the thin film transistor array panel and the manufacturing method thereof according to the embodiment of the present invention, the results obtained by measuring the charge mobility of the source electrode 134 and the drain electrode 135 are illustrated in FIG. 42.

In FIG. 42, the case A corresponds to the charge mobility measured in the semiconductor pattern 132 after the semiconductor pattern 132 is formed and the case B1 corresponds to the charge mobility measured in the source electrode 134 and the drain electrode 135 after the semiconductor pattern 132 is subjected to the first reduction processing to form the channel region 133 and the source electrode 134 and the drain electrode 135 having the conductivity. The case B2 corresponds to the charge mobility measured in a portion of the source electrode 134 and the drain electrode 135 exposed by the contact holes 164 and 165 after the passivation layer 160 is deposited on the channel region 133, the source electrode 134, and the drain electrode 135 and the contact holes 164 and 165 are formed. Further, the case C corresponds to the charge mobility measured in the first source region 134a and the first drain region 135a after the first source region 134a and the first drain region 135a are formed by performing the second reduction processing on a portion of the source electrode 134 and the drain electrode 135 exposed by the contact holes 164 and 165.

Referring to FIG. 42, as in the thin film transistor, the thin film transistor array panel, and the manufacturing method thereof according to the embodiment of the present invention, when the exposed portion of the semiconductor pattern 132 is subjected to the first reduction processing, the source electrode 134 and the drain electrode 135 have a high charge mobility similar to metal, for example, the charge mobility of about 1x10¹⁷, such that the source electrode 134 and the drain electrode 135 may serve as the source electrode 134 and the drain electrode 135.

Further, as described above, when the passivation layer 160 is deposited on the source electrode 134 and the drain electrode 135 and the contact holes 164 and 165 are formed, a portion of the source electrode 134 and the drain electrode 135 exposed by the contact holes 164 and 165 contacts an etchant, etch gas, or oxygen in the air to oxidize at least a portion thereof again, such that the charge mobility is reduced to about 1x10¹⁷.

However, as in the thin film transistor, the thin film transistor array panel, and the manufacturing method thereof according to the embodiment of the present invention, portions of the source electrode 134 and the drain electrode 135 exposed by the contact holes 164 and 165 are subjected to the second reduction processing, such that the first source region 134a and the first drain region 135a having a charge mobility greater than that of the remaining source electrode 134 and the drain electrode 135, that is, a charge mobility greater than 1x10¹⁷, for example, about 1x10²⁰ are formed.

As described above, according to the embodiment of the present invention, the data input electrode 174 is connected to the first source region 134a having a large charge mobility in the source electrode 134 and the data output electrode 175 is connected to the first drain region 135a having a large charge mobility in the drain electrode 135, such that the data input electrode 174 and the data output electrode 175 may have more secure electrically connections to the source electrode 134 and the drain electrode 135.

Furthermore, because the gate electrode 154 of the thin film transistor Q does not overlap with the source electrode 134 or the drain electrode of the thin film transistor Q, or the overlapping portion therebetween may be very small, the parasitic capacitance between the gate electrode 154 and the source electrode 134 or the parasitic capacitance between the gate electrode 154 and the drain electrode 135 may be very small. Therefore, the on-current and the mobility of the thin film transistor can be increased and the on/off characteristics of the switching element of the thin film transistor Q can be improved. Consequently, the RC delay can be reduced in the display device to which the thin film transistor is applied. Therefore, the margin reducing the thickness of the driving signal line can be secured, thereby reducing the manufacturing costs. Further, the characteristics of the thin film transistor itself can be improved, thereby reducing the size of the thin film transistor and more securing the margin forming the fine channel.

It will be apparent to those skilled in the art that various modifications and variations can be made in the present invention without departing from the scope of the invention. Thus, it is intended that the present invention cover the modifications and variations of this invention provided they come within the scope of the appended claims and their equivalents.

## Claims

1. A thin film transistor, comprising:
a channel region comprising an oxide semiconductor;
a source electrode and a drain electrode connected to the channel region, the channel region being disposed between the source electrode and the drain electrode, and the drain electrode comprising a first drain region and a second drain region;
an insulating layer disposed on the channel region;
a gate electrode disposed on the insulating layer; and
a passivation layer disposed on the source electrode and the drain electrode and having a first contact hole exposing the first drain region of the drain electrode, and
wherein the charge mobility of the first drain region is greater than or equal to the charge mobility of the second drain region.

2. A thin film transistor according to claim 1, wherein:
the source electrode comprises a first source region and a second source region,
the passivation layer comprises a second contact hole exposing the first source region of the source electrode, and
the charge mobility of the first source region is greater than or equal to the charge mobility of the second source region.

3. A thin film transistor according to claim 1 or 2, wherein:
the source electrode and the drain electrode comprise a material obtained by reducing a material forming the oxide semiconductor.

4. A thin film transistor according to claim 3, wherein:
an edge of the gate electrode and an edge of the channel region are substantially aligned with each other.

5. A thin film transistor according to claim 4, wherein:
an edge of the gate electrode and an edge of the insulating layer are substantially aligned with each other.

6. A thin film transistor according to claim 2 or any claim dependent upon claim 2, wherein:
a metal component of the oxide semiconductor material is precipitated on a surface of at least a portion of the first source region and the first drain region.

7. A thin film transistor according to claim 6, wherein:
the metal component of the oxide semiconductor material is indium (In).

8. A thin film transistor according to claim 2 or any claim dependent upon claim 2, further comprising:
a source conductor disposed on the first source region; and
a drain conductor disposed on the first drain region.

9. A thin film transistor according to any preceding claim, wherein:
the charge mobility of the first drain region exceeds 1x10¹⁷ and the charge mobility of the second drain region is about 1x10¹⁷.

10. A thin film transistor array panel, comprising:
a substrate;
a channel region disposed on the substrate and comprising an oxide semiconductor;
a source electrode and a drain electrode connected to the channel region, the channel region being disposed between the source electrode and the drain electrode, the drain electrode comprising a first drain region and a second drain region, and the source electrode comprising a first source region and a second source region;
an insulating layer disposed on the channel region; and
a gate electrode disposed on the insulating layer"
wherein the charge mobility of the first drain region is greater than or equal to the charge mobility of the second drain region,
wherein
the charge mobility of the first source region is greater than or equal to the charge mobility of the second source region.

11. A thin film transistor array panel according to claim 10, further comprising:
a data input unit connected to the first source region of the source electrode; and
a data output unit connected to the first drain region of the drain electrode.

12. A thin film transistor array panel according to claim 10 or 11, wherein:
the source electrode and the drain electrode comprise a material obtained by reducing a material forming the oxide semiconductor.

13. A thin film transistor array panel according to claim 10, 11 or 12 further comprising:
a passivation layer disposed on the source electrode and the drain electrode and comprising a source contact hole exposing the first source region of the source electrode and a drain contact hole exposing the first drain region of the drain electrode.

14. A thin film transistor array panel according to claim 13, wherein:
edges of the gate electrode and edges of the oxide semiconductor are substantially aligned.

15. A thin film transistor array panel acording to claim 14, wherein:
an edge of the gate electrode and an edge of the insulating layer are substantially aligned with each other.
